# FASCICULE DE BREVET EUROPEEN

(11) **EP 2 206 094 B1**
(45) Date de publication et mention de la délivrance du brevet: **10.10.2012**
(21) Numéro de dépôt: 08835677.9
(22) Date de dépôt: 18.09.2008
(51) Int. Cl.: G07C 9/00, H01Q 1/32, E05B 65/20

(54) **DISPOSITIF DE DÉTECTION DE PRÉSENCE D'UN UTILISATEUR PAR UN VÉHICULE**
VORRICHTUNG ZUR ERFASSUNG DER PRÄSENZ EINES BENUTZERS DURCH EIN FAHRZEUG
DEVICE FOR DETECTING THE PRESENCE OF A USER BY A VEHICLE

(30) Priorité: 03.10.2007 FR 0706951; 01.07.2008 FR 0803777
(43) Date de publication de la demande: 14.07.2010
(73) Titulaire: Valeo Sécurité Habitacle, 94046 Créteil Cedex (FR); Violleau, Stephane, 94042 Creteil (FR); Bocage, Frederic, 94042 Creteil (FR)
(72) Inventeur: CARA, Hervé, F-94042 Creteil (FR); NGUYEN, VAN-QUYN, F-94042 Creteil Cedex (FR)
(74) Mandataire: Jacquot, Ludovic R. G.
(86) Numéro de dépôt international: PCT/EP2008/062457
(87) Numéro de publication internationale: WO 2009/043734

(56) Documents cités:
- EP-A- 0 955 431
- EP-A- 1 450 489
- EP-A- 1 473 426
- DE-A1- 10 206 968
- DE-A1- 10 330 525

## Description

### Domaine de l'invention

La présente invention concerne un dispositif de détection de présence d'un objet, le dispositif comprenant au moins un organe de détection auquel est associée une grandeur physique qui varie en fonction de l'environnement où est placé ledit organe de détection, et un procédé de détection associé.

Elle trouve une application particulière dans le domaine des véhicules automobiles.

### Etat de la technique

Un tel dispositif de détection de présence pour véhicule automobile permet de détecter la présence d'un objet tel qu'une main d'un utilisateur du véhicule qui coopère avec une poignée d'ouvrant du véhicule, le dispositif de détection permettant alors de déverrouiller automatiquement le véhicule (par exemple lorsque la main est insérée dans la poignée), ou permettant de verrouiller automatiquement le véhicule (par exemple lorsque la main touche la poignée).
A cet effet, le dispositif utilise un organe de détection tel que par exemple un jeu d'électrodes, la grandeur physique associée audit jeu étant par exemple une capacité. Dans ce cas, un objet tel qu'une main peut être détecté par ce jeu d'électrodes lorsque la capacité entre le jeu d'électrodes varie.
Un tel dispositif de détection de présence peut entraîner l'excitation d'une antenne basse fréquence qui à la suite d'une détection de présence d'un objet envoie un signal basse fréquence en direction d'un objet d'identification détenu par l'utilisateur pour vérifier l'identité dudit objet d'identification. Ce dernier envoie alors un signal radiofréquence en direction de l'antenne pour s'authentifier.
Un problème d'un tel dispositif est que lors de l'émission du signal basse fréquence par l'antenne, la grandeur physique est perturbée par le signal basse fréquence. Le dispositif de détection est donc brouillé et ne peut donc plus détecter aucune présence d'objet tel qu'une main de sorte que lorsqu'un utilisateur met sa main dans la poignée pendant l'émission du signal basse fréquence et ne la retire qu'après, une telle présence de main après l'émission du signal
basse fréquence n'est pas détectée. Les documents EP 0955 431 et DE 10330525 décrivent des dispositifs de détection.

### Objet de l'invention

La présente invention a pour but de permettre la détection de la présence d'un objet tel qu'une main d'un utilisateur qui coopère avec une poignée de véhicule, lorsqu'elle est présente même après l'émission d'un signal basse fréquence.

Selon un premier objet de l'invention, ce but est atteint par un dispositif de détection de présence d'un objet, le dispositif comprenant au moins un organe de détection auquel est associée une grandeur physique qui varie en fonction de l'environnement où est placé ledit organe de détection. Selon la revendication 1.

Comme on va le voir en détail par la suite, la valeur du niveau de référence sauvegardée va servir de référence pour la détection d'un objet après l'émission du signal basse fréquence. Ainsi, la variation de la grandeur physique par rapport à cette valeur de niveau référence sera toujours visible lorsqu'un objet tel qu'une main sera présent après l'émission du signal basse fréquence. La présence d'un objet après l'émission du signal basse fréquence sera ainsi toujours détecté.

Selon des modes de réalisation non limitatifs, le dispositif présente en outre les caractéristiques suivantes.
- Le dispositif de sauvegarde permet en outre de :
   - mesurer la grandeur physique associée à l'organe de détection; et
   - comparer la grandeur physique à la valeur du niveau de référence sauvegardée.
- le dispositif de sauvegarde permet en outre de suspendre la variation du niveau de référence. Cela permet de figer la valeur du niveau de référence qui ne sera ainsi pas modifié par les mesures de la grandeur physique qui ne sont pas dues à l'environnement seul.
- La suspension de la variation du niveau de référence est effectuée dès que la présence d'un objet est détecté ou dès qu'un signal basse fréquence est émis. Cela permet d'avoir une valeur de niveau de référence sauvegardée avant la détection d'un objet ou avant l'émission d'un signal basse fréquence.
- Le dispositif de sauvegarde permet de libérer ladite sauvegarde après l'émission du signal basse fréquence. Cela permet à la grandeur physique de délivrer de nouveau un niveau de référence variable lorsqu'il n'y a pas d'objet.
- La grandeur physique est une capacité. Cela permet d'avoir une zone étendue de détection d'un objet, tout le long d'une poignée de véhicule par exemple.
- La grandeur physique est un flux lumineux. Le système de détection est alors plus simple à mettre en oeuvre avec un flux lumineux.
- Le dispositif de détection comporte en outre un élément de détection basse fréquence de début d'émission d'un signal basse fréquence. Cela permet de sauvegarder une valeur de niveau de référence pendant toute la durée de l'émission d'un signal basse fréquence.
- Le dispositif de détection est alimenté par une alimentation commune à une antenne d'émission d'un signal basse fréquence. Cela permet de diminuer le nombre de fils, sur un véhicule par exemple.
- Le dispositif de détection est alimenté, pendant l'émission d'un signal basse fréquence, par une tension d'excitation d'une antenne, ladite antenne permettant d'émettre le signal basse fréquence. Cela permet d'alimenter le dispositif de détection lorsque son alimentation continue est coupée du fait de l'émission du signal basse fréquence.
- Le dispositif de détection est alimenté par une tension d'entrée et il comprend en outre un condensateur d'entrée pour emmagasiner de l'énergie à partir de la tension d'entrée. Cela permet de faire fonctionner l'organe de détection.
- Le dispositif de détection comprend en outre des moyens de mesure associés à un organe de détection pour générer une grandeur électrique de sortie lorsque ledit organe de détection détecte la présence d'un objet.
- Le dispositif de détection comprend en outre des moyens d'inhibition pour inhiber des moyens de mesure de sorte qu'ils ne génèrent plus de grandeur électrique.
- Dans un premier mode de réalisation, les moyens de mesure comprennent un générateur de courant associé à chaque organe de détection, et une grandeur électrique de sortie est un courant de sortie générateur.
- Dans un deuxième mode de réalisation, les moyens de mesure comprennent un unique générateur de courant associé à tous les organes de détection, et une grandeur électrique de sortie est un courant de sortie générateur.
- Dans un troisième mode de réalisation, les moyens de mesure comprennent un interrupteur connecté à la masse associé à chaque organe de détection, et une grandeur électrique de sortie est une tension de sortie générateur.
- Dans un quatrième mode de réalisation, les moyens de mesure comprennent un unique interrupteur connecté à la masse associé à tous les organes de détection, et une grandeur électrique de sortie est une tension de sortie générateur.
- Selon un premier mode de réalisation non limitatif, l'élément de détection basse fréquence comporte un comparateur pour détecter une coupure d'alimentation dudit dispositif de détection. Ainsi, grâce à la détection de la coupure d'alimentation continue, on sait qu'un signal basse fréquence va être émis par la suite.
- Le comparateur permet de comparer la tension aux bornes du condensateur d'entrée avec la tension d'entrée. C'est un moyen simple pour détecter une coupure d'alimentation continue du dispositif de détection, une telle coupure indiquant un début d'émission d'un signal basse fréquence qui va suivre.
- Les moyens d'inhibition permettent d'inhiber des moyens de mesure lorsqu'une coupure d'alimentation dudit dispositif de détection est détectée. Ainsi l'inhibition s'effectue avant le début de l'émission d'un signal basse fréquence. On est ainsi sûr que les moyens de mesure sont inhibés lors de l'émission d'un signal basse fréquence.
- Les moyens d'inhibition permettent d'inhiber des moyens de mesure lorsque la tension d'entrée est inférieure à la tension aux bornes du condensateur d'entrée moins un premier seuil. Ainsi lesdits moyens de mesure ne génèrent plus de grandeur électrique de sortie et cela évite à un dispositif de détection qui est capacitif d'être brouillé par une émission d'un signal basse fréquence. Cela permet également de filtrer les signaux parasites de la tension d'entrée grâce au premier seuil de tension.
- Le dispositif de sauvegarde sauvegarde la valeur du niveau de référence mesurée avant l'émission d'un signal basse fréquence, jusqu'à ce que la tension d'entrée soit supérieure à la tension aux bornes du condensateur d'entrée moins un deuxième seuil. Cela permet à un contrôleur externe de voir à nouveau l'état du dispositif de détection grâce au courant consommé par ledit dispositif de détection, et donc de voir la présence d'un objet.
- Le dispositif de détection comporte en outre un premier filtre temporel pour mesurer la durée de la coupure d'alimentation et n'autoriser la sauvegarde de la valeur du niveau de référence mesurée avant l'émission du signal basse fréquence que si ladite durée est supérieure à un premier temps prédéterminé. Cela évite de faire une sauvegarde inutile lors de micro-coupures d'alimentation.
- Le dispositif de détection comporte en outre un deuxième filtre temporel pour libérer la sauvegarde de la valeur du niveau de référence mesurée avant l'émission du signal basse fréquence, lorsque la tension d'entrée est égale à la tension aux bornes du condensateur d'entrée pendant une durée supérieure à un deuxième temps prédéterminé. Cela évite de confondre l'émission d'un signal basse fréquence par une antenne avec la réalimentation en tension du dispositif de détection par la tension d'entrée. On ne réactive donc pas les moyens de mesure pendant l'émission d'un signal basse fréquence.
- Selon un deuxième mode de réalisation non limitatif, l'élément de détection basse fréquence comporte un comparateur pour détecter un signal résonnant représentatif de l'émission d'un signal basse fréquence. Cela permet de détecter l'émission d'un tel signal basse fréquence au moyen d'une antenne qui est un circuit résonnant, un tel signal résonnant étant nettement supérieur à la tension d'alimentation de l'antenne.
- L'élément de détection basse fréquence comporte un détecteur crête pour permettre une détection crête à partir du signal résonnant. La détection crête est simple à mettre en oeuvre et va permettre la détection de l'émission d'un signal basse fréquence.
- Le comparateur permet de comparer une tension de résonance générée par une antenne et une tension de référence, ladite antenne permettant d'émettre le signal basse fréquence. C'est un moyen simple de détecter un signal résonnant.
- Le signal résonnant est une tension image d'un courant résonnant circulant dans une antenne permettant d'émettre le signal basse fréquence. C'est un moyen simple de détecter un signal résonnant.
- Les moyens d'inhibition permettent d'inhiber des moyens de mesure lorsque que l'émission d'un signal basse fréquence est détectée. Cela évite à une émission basse fréquence d'être brouillée par le dispositif de détection.
- Selon un troisième mode de réalisation non limitatif, l'élément de détection basse fréquence comporte un comparateur pour détecter un signal d'entrée pulsé représentatif de l'émission d'un signal basse fréquence. Ce signal est simple à observer.
- L'élément de détection basse fréquence comporte un détecteur crête pour permettre une détection crête à partir du signal d'entrée pulsé. La détection crête est simple à mettre en oeuvre et va permettre la détection de l'émission d'un signal basse fréquence.
- L'élément de détection basse fréquence comporte en outre un condensateur supplémentaire. Cela évite de réenclencher de façon intempestive un moyen de mesure lorsque le signal d'entrée redevient continu. De plus, cela permet de détecter plus rapidement l'émission d'un signal basse fréquence.
- L'élément de détection basse fréquence comporte en outre une résistance supplémentaire qui associée à un condensateur permet une remise en route de la détection après l'émission d'un signal basse fréquence. Cela permet au condensateur du filtre de pouvoir se décharger et par la suite de désactiver l'inhibition des moyens de mesure du capteur.
- Le détecteur crête comporte une constante de temps définie de manière à minimiser le temps de détection de l'émission d'un signal basse fréquence en contrôlant le temps de charge dudit détecteur crête. Ainsi, plus vite on aura détecté l'émission du signal basse fréquence, plus vite on pourra sauvegarder la valeur du niveau de référence et plus vite on pourra inhiber les moyens de mesure du capteur pour éviter une réinitialisation intempestive dudit capteur. On évite donc la perte de la sauvegarde de la référence.
- Le détecteur crête comporte une constante de temps définie de manière à éviter des pics de perturbations parasites transitoires du signal d'entrée pulsé lors du chargement dudit détecteur crête. Cela évite des inhibitions non voulues des moyens de mesure du capteur.

Selon un deuxième objet de l'invention, elle concerne une unité de détection d'un objet, caractérisé en ce qu'elle comprend :
- un dispositif de détection selon l'une des caractéristiques précédentes ; et
- une antenne pour émettre un signal basse fréquence.

Selon un troisième objet de l'invention, elle concerne un procédé de détection de présence d'un objet au moyen d'une grandeur physique, associée à un organe de détection, qui varie en fonction de l'environnement où est placé ledit organe de détection, caractérisé en ce qu'il comprend les étapes de :
- délivrer un niveau de référence variable de la grandeur physique et correspondant à l'absence d'un objet; et
- sauvegarder, pendant l'émission d'un signal basse fréquence, une valeur du niveau de référence mesurée avant l'émission dudit signal basse fréquence.

Selon des modes de réalisation non limitatifs, le procédé présente en outre les caractéristiques suivantes.
- Le procédé comporte en outre les étapes supplémentaires de :
   - mesurer la grandeur physique associée à l'organe de détection ; et
   - comparer la grandeur physique à la valeur du niveau de référence sauvegardée.
- Le procédé comporte en outre l'étape supplémentaire de suspendre la variation du niveau de référence.
- Le procédé comporte en outre l'étape supplémentaire de libérer ladite sauvegarde après l'émission du signal basse fréquence.
- La suspension de la variation du niveau de référence est effectuée dès que la présence d'un objet est détecté ou dès qu'un signal basse fréquence est émis.

Selon un quatrième objet de l'invention, elle concerne un produit programme d'ordinateur comportant une ou plusieurs séquences d'instructions exécutables par une unité de traitement d'information, l'exécution desdites séquences d'instructions permettant une mise en oeuvre du procédé selon la caractéristique précédente.

### Brève description des figures

D'autres caractéristiques et avantages de la présente invention seront mieux compris à l'aide de la description et des dessins non limitatifs parmi lesquels :
- la Fig. 1 représente un diagramme d'un mode de réalisation non limitatif d'une unité de détection comprenant un dispositif de détection et une antenne associée selon l'invention ;
- la Fig. 2 représente deux diagrammes expliquant le fonctionnement du dispositif de détection de présence d'un objet de la Fig. 1 ;
- la Fig. 3 est un diagramme détaillé du dispositif de détection de présence d'un objet de la Fig. 1 comportant des moyens de mesure selon un premier mode de réalisation non limitatif ;
- la Fig. 4 est un diagramme détaillé d'un premier mode de réalisation non limitatif du dispositif de détection de présence de la Fig. 1 ;
- la Fig. 5 représente différents diagrammes concernant :
   - l'évolution d'une tension d'entrée du dispositif de détection de présence de la Fig. 4 et l'évolution d'une tension aux bornes d'un condensateur d'entrée dudit dispositif lors d'un émission d'un signal basse fréquence par une antenne basse fréquence coopérant avec ledit dispositif ;
   - la sortie d'un comparateur du dispositif de détection de présence de la Fig. 4 ;
   - les états de gel de la configuration du dispositif de détection de présence de la Fig. 4 ;
   - les états de désactivation/activation de la sortie en courant du dispositif de détection de présence de la Fig. 4 ;
   - L'évolution de la charge d'un condensateur du dispositif de détection de présence de la Fig. 4 ;
   - la présence ou non d'une main d'un utilisateur dans une poignée du véhicule, ladite présence étant détectée par le dispositif de détection de présence de la Fig. 4 ; et
   - l'évolution du courant consommé par l'unité de détection de présence de la Fig. 1 comportant le dispositif de détection de présence de la Fig. 4 ;

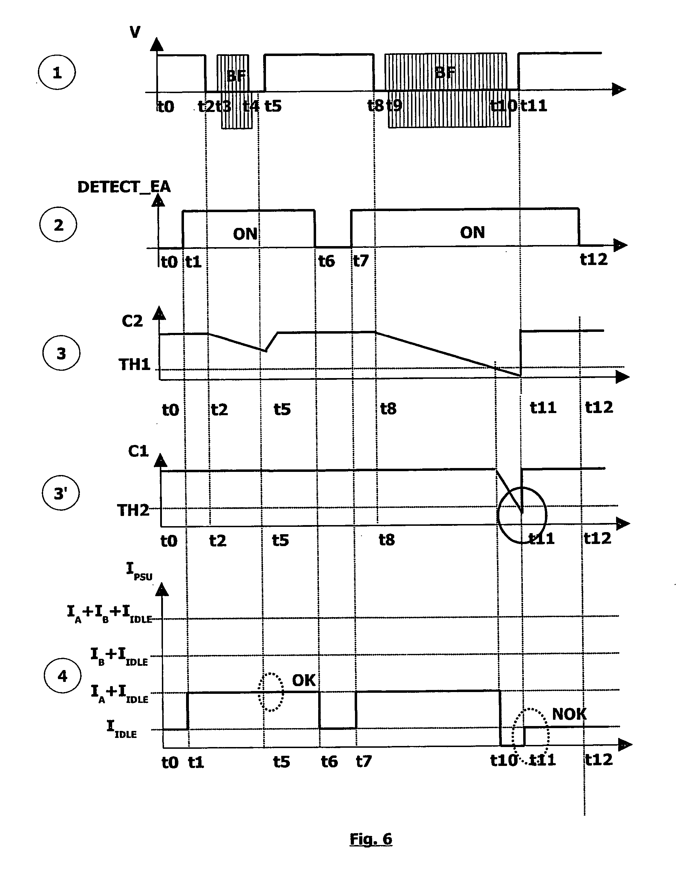

- la Fig. 6 représente différents diagrammes d'un dispositif de détection de présence de l'état de la technique antérieur concernant :
   - l'évolution de la tension d'entrée d'un tel dispositif de détection de présence ;
   - la présence ou non d'une main d'un utilisateur coopérant avec une poignée du véhicule, ladite présence étant détectée par un tel dispositif de détection de présence ;
   - L'évolution de la charge d'un premier condensateur d'un tel dispositif de détection de présence ;
   - L'évolution de la charge d'un deuxième condensateur d'un tel dispositif de détection de présence ; et
   - l'évolution du courant consommé par une unité de détection de présence comportant un tel dispositif de détection de présence ;

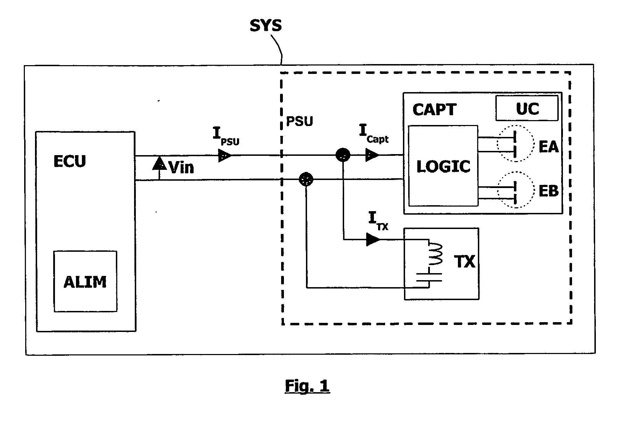

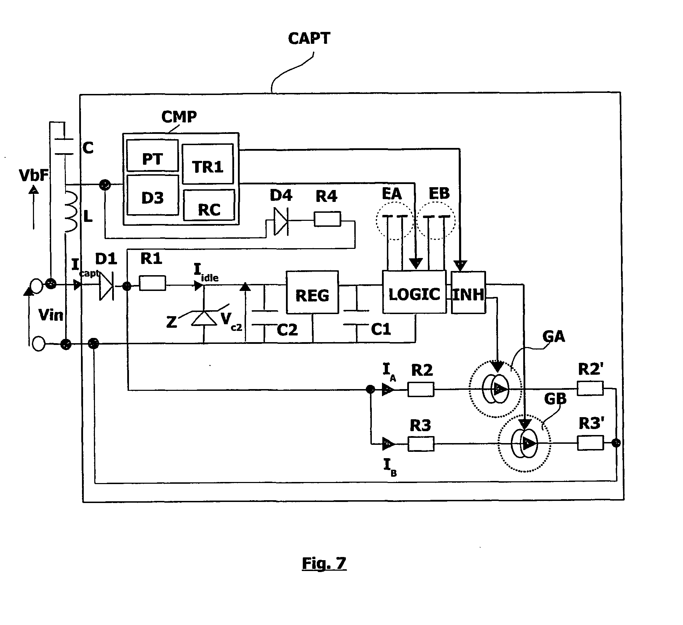

- la Fig. 7 est un diagramme détaillé d'une première variante de réalisation d'un deuxième mode de réalisation non limitatif du dispositif de détection de présence de la Fig. 1 ;

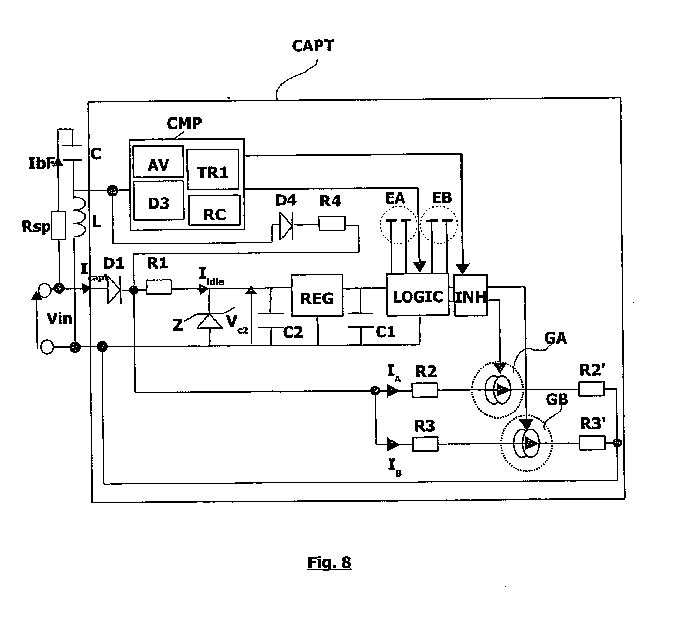

- la Fig. 8 est un diagramme détaillé d'une deuxième variante de réalisation d'un deuxième mode de réalisation non limitatif du dispositif de détection de présence de la Fig. 1 ;

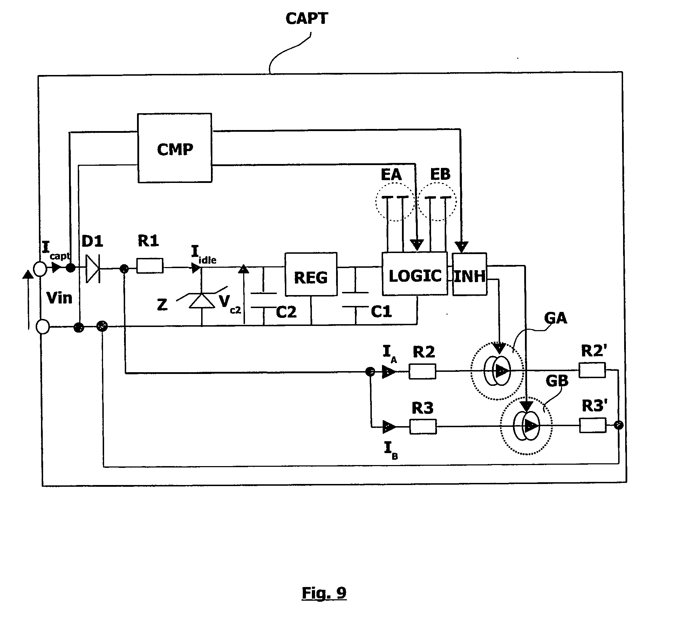

- la Fig. 9 est un diagramme détaillé d'un troisième mode de réalisation non limitatif du dispositif de détection de présence de la Fig. 1 ;

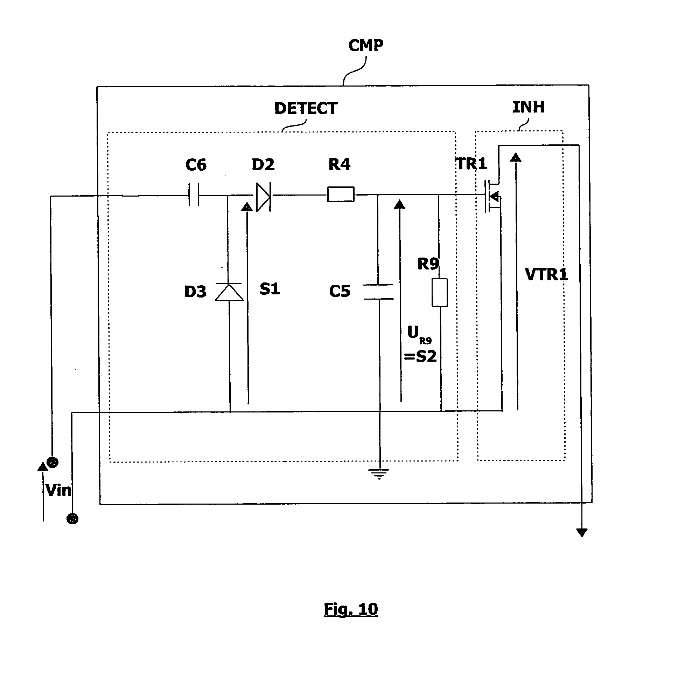

- la Fig. 10 est un diagramme détaillé d'une partie du troisième mode de réalisation de la Fig. 9 ;

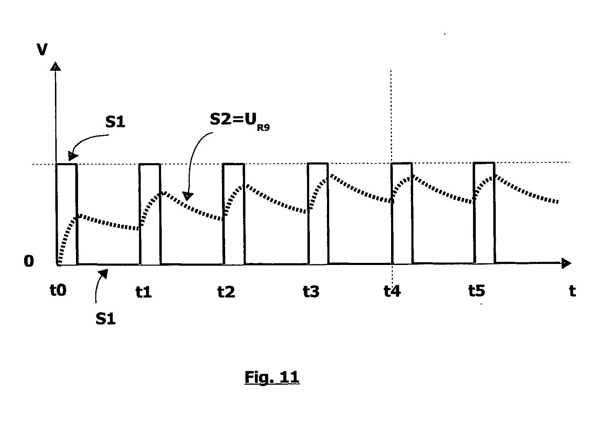

- la Fig. 11 est un diagramme montrant de façon schématique deux signaux de sortie issus du dispositif de détection de présence de la Fig. 9 ;

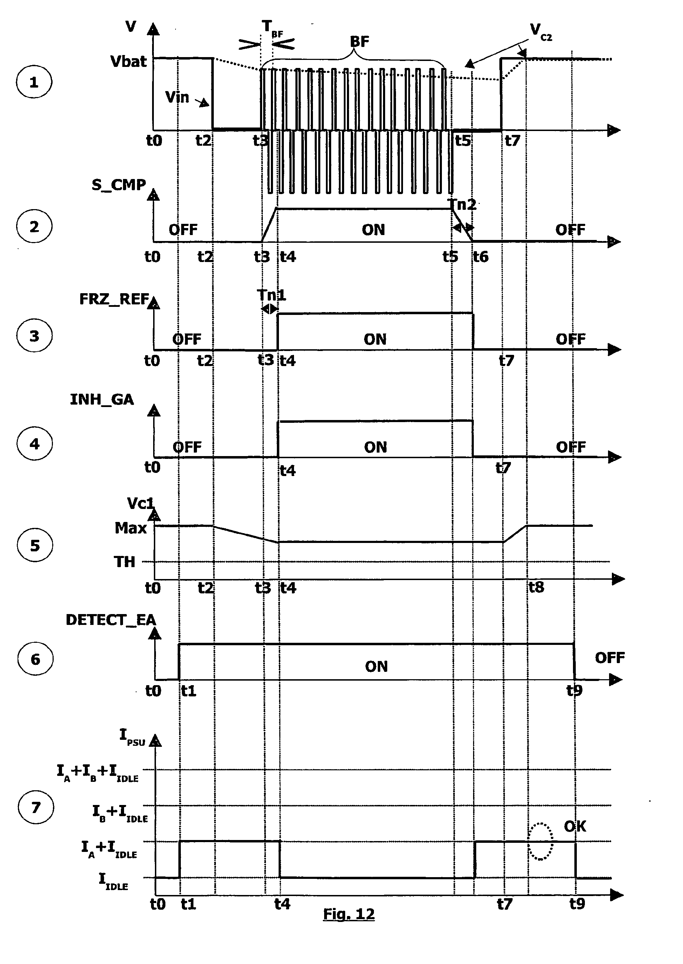

- la Fig. 12 représente différents diagrammes concernant :
   - l'évolution d'une tension d'entrée du dispositif de détection de présence de la Fig. 9 et l'évolution d'une tension aux bornes d'un condensateur d'entrée dudit dispositif lors d'un émission d'un signal basse fréquence par une antenne basse fréquence coopérant avec ledit dispositif ;
   - la sortie d'un comparateur du dispositif de détection de présence de la Fig. 9 ;
   - les états de gel de la configuration du dispositif de détection de présence de la Fig. 9 ;
   - les états de désactivation/activation de la sortie en courant du dispositif de détection de présence de la Fig. 9 ;
   - L'évolution de la charge d'un condensateur du dispositif de détection de présence de la Fig. 9 ;
   - la présence ou non d'une main d'un utilisateur dans une poignée du véhicule, ladite présence étant détectée par le dispositif de détection de présence de la Fig. 9 ; et
   - l'évolution du courant consommé par l'unité de détection de présence de la Fig. 1 comportant le dispositif de détection de présence de la Fig. 9 ;

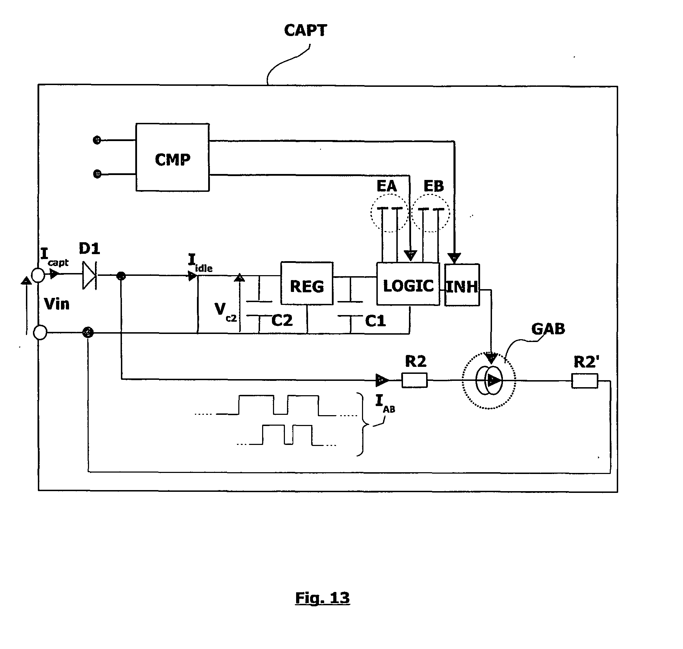

- la Fig. 13 représentent un dispositif de détection de présence d'un objet de la Fig. 1 comportant des moyens de mesure selon un deuxième mode de réalisation non limitatif ;

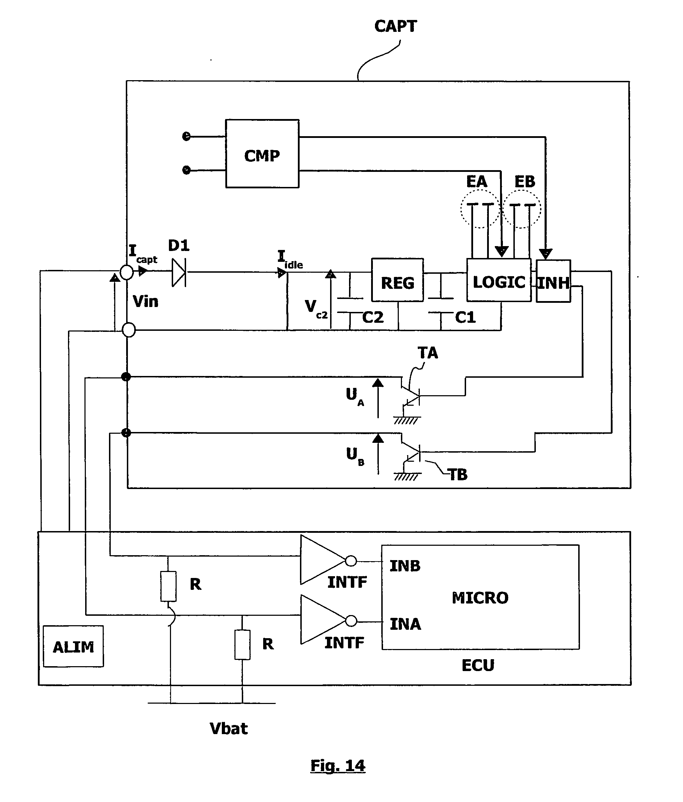

- la Fig. 14 représentent un dispositif de détection de présence d'un objet de la Fig. 1 comportant des moyens de mesure selon un troisième mode de réalisation non limitatif ; et

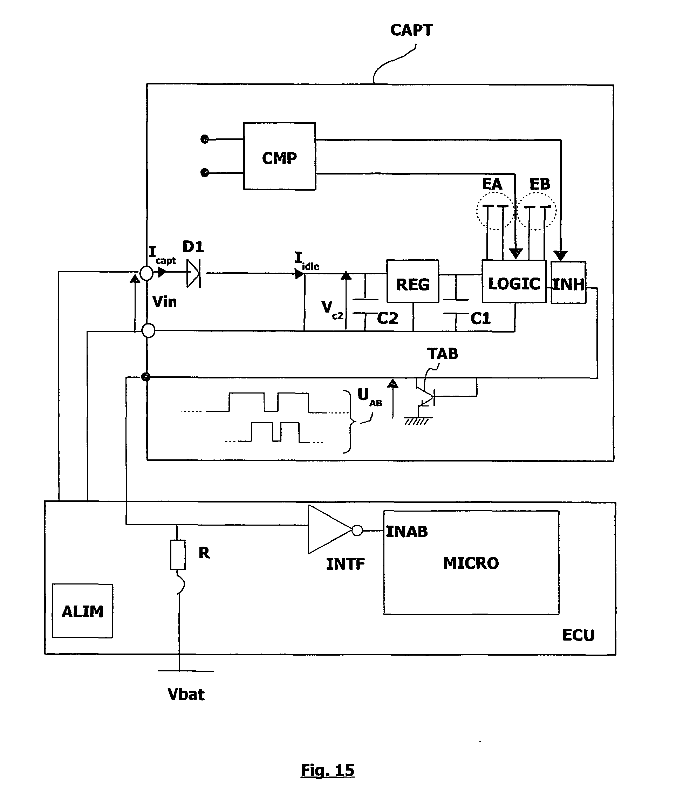

- la Fig. 15 représentent un dispositif de détection de présence d'un objet de la Fig. 1 comportant des moyens de mesure selon un quatrième mode de réalisation non limitatif.

### Description détaillée de modes de réalisation non limitatifs de l'invention

Une unité de détection de présence PSU d'un objet O comprenant un dispositif de présence CAPT selon l'invention est décrit dans un mode de réalisation non limitatif à la Fig. 1.

Elle est décrite pour une application véhicule automobile non limitative. Un objet O tel qu'une main d'un utilisateur d'un véhicule automobile est donc considéré comme exemple.

L'unité de détection de présence PSU comprend :
- au moins un dispositif de détection CAPT pour un véhicule automobile V pour détecter la présence d'une main d'un utilisateur du véhicule coopérant avec une poignée P d'ouvrant du véhicule (avec ou sans contact). Le dispositif CAPT est alimenté par une tension d'entrée (ou tension d'entrée) Vin. Dans un exemple non limitatif, le véhicule V comporte entre 3 et 5 ouvrants (portières, coffre) avec une poignée P associée.
Au moins un dispositif CAPT est associé à chaque poignée P. Dans un exemple non limitatif, une poignée P comporte deux dispositifs CAPT ; et
- une antenne TX pour émettre un signal basse fréquence BF en direction d'un objet d'identification ID, détenu par l'utilisateur du véhicule automobile, de sorte à vérifier si l'objet d'identification ID est bien dédié au véhicule V. L'émission se fait soit régulièrement (méthode de « polling » en anglais), soit lorsqu'une présence de main qui coopère avec une poignée P est détectée par le dispositif CAPT. L'antenne TX est, dans un exemple non limitatif, placée dans la poignée P. Dans un exemple non limitatif, elle comporte une inductance L (avec un noyau magnétique en ferrite) et une capacité C. Une telle antenne étant connue de l'homme du métier, elle n'est pas décrite plus en détail ici.

On notera que le dispositif CAPT et l'antenne TX sont disposés à proximité l'un de l'autre (pour éviter d'avoir des fils de connexion trop longs) et peuvent être placés dans un même boîtier électronique ou dans des boîtiers différents.

L'unité de détection de présence PSU est relié à un contrôleur ECU, dans l'exemple le contrôleur d'habitacle du véhicule V, qui permet de détecter l'état du dispositif CAPT par la mesure d'un courant commun Ipsu consommé par l'unité de détection de présence PSU comme on va le voir en détail plus loin.

Cette unité de détection PSU fait elle-même partie d'un système mains libres SYS qui permet un accès sans clef au véhicule V. Ce système mains libres comporte une alimentation ALIM permettant d'alimenter en tension d'entrée Vin ladite unité de détection de présence PSU.
Dans un exemple non limitatif, cette tension d'entrée Vin est fournie par la tension batterie Vbat du véhicule, qui est par exemple de 12 Volts. On peut bien entendu prévoir une autre valeur de tension.

Dans un mode de réalisation non limitatif, l'antenne TX et le dispositif de détection CAPT sont reliés en parallèle (sur deux mêmes fils) comme illustrés à la Fig. 1. Ainsi, cela permet au dispositif de détection CAPT d'être alimenté par une alimentation commune à l'antenne TX. On a un même faisceau d'alimentation pour l'antenne TX et le dispositif CAPT (la tension d'entrée Vin est donc la tension commune) ce qui permet de réduire le nombre de fils nécessaire à l'alimentation par rapport à une alimentation individuelle. On limite ainsi le nombre de fils sur le véhicule V.

Dans un mode de réalisation non limitatif, le dispositif de détection CAPT est alimenté, pendant l'émission d'un signal basse fréquence BF (que l'on appellera également émission BF), par une tension de résonance générée par l'antenne TX. Cela permet d'alimenter le dispositif de détection CAPT lorsque son alimentation continue est coupée du fait de l'émission du signal basse fréquence et donc en particulier dans le cas d'une alimentation commune.

Dans le cadre de l'application véhicule, le dispositif de détection CAPT va permettre de détecter une intention d'un utilisateur d'effectuer une action sur le véhicule. En particulier, le dispositif CAPT va permettre de détecter l'intention de l'utilisateur de verrouiller/déverrouiller le véhicule en mettant sa main respectivement sur (donc en contact avec) une poignée P d'ouvrant du véhicule/dans une poignée P d'ouvrant du véhicule (avec ou sans contact). Plus particulièrement, le dispositif de détection CAPT va donc permettre de détecter une main qui coopère avec une poignée d'ouvrant du véhicule comme on va la voir en détail ci-après.

Le dispositif de détection CAPT comporte notamment :
- au moins un organe de détection EA/EB, relié à un dispositif de sauvegarde LOGIC, pour détecter la présence d'une main qui coopère avec une poignée P. Dans un exemple non limitatif, il comporte deux organes de détection EA/EB comme illustré sur la Fig. 1. Une grandeur physique CE est associée à chaque organe de détection EA/EB ; et
- un dispositif de sauvegarde LOGIC pour sauvegarder, pendant l'émission d'un signal basse fréquence, une valeur de niveau de référence REF de la grandeur physique CE mesurée avant l'émission dudit signal basse fréquence BF.

Dans un exemple non limitatif, le dispositif de sauvegarde LOGIC est un circuit intégré de commande.
De plus, il permet de :
- mesurer les grandeurs physiques associées à chaque organe de détection EA/EB,
- scruter les variations du niveau de référence desdites grandeurs physiques, et
- comparer la valeur de la grandeur physique CE à la valeur du niveau de référence REF sauvegardé.

Dans un premier exemple non limitatif, le dispositif de détection CAPT est capacitif. Les organes de détection EA/EB sont des jeux d'électrode(s) formant une capacité, la grandeur physique associée à chaque jeu d'électrode(s) étant une capacité. Cela permet d'avoir une plus grande zone de détection qui couvre toute la poignée P dans le cas de l'application véhicule automobile.

Dans un deuxième exemple non limitatif, le dispositif de détection CAPT est optique. La grandeur physique associée à chaque organe de détection EA/EB est un flux lumineux.

La grandeur physique CE associée à chaque organe de détection EA/EB varie en fonction :
- a) de l'environnement dans lequel est placé ledit organe de détection, et
- b) de la présence d'un objet O à proximité dudit organe de détection.

Dans le premier cas a), comme l'environnement d'un organe de détection EA/EB n'est pas totalement stable en raison d'éléments perturbateurs, tels que par exemple une atmosphère humide où d'ondes radio extérieures etc., qui ne sont pas liés à la présence d'un objet O tel qu'une main d'un utilisateur, la grandeur physique CE associée à l'organe de détection EA/EB présente de micro-variations dues à cet environnement, ces micro-variations étant très lentes dans le temps également. Ces micro-variations représentent donc la nature de l'environnement de l'organe de détection EA/EB. La grandeur physique CE associée à chaque organe de détection EA/EB délivre ainsi un niveau de référence REF variable et correspondant à l'absence d'une présence d'un objet O. Le niveau de référence REF prend donc en compte ces micro-variations. Il y a donc une auto-adaptation du niveau de référence REF à ses micro-variations.
Dans l'exemple d'un organe de détection EA/EB tel qu'un jeu d'électrode(s), la grandeur physique CE est la capacité du jeu d'électrode(s) dans cet environnement.

Dans le deuxième cas b), lorsqu'un objet O s'approche d'un organe de détection EA/EB de manière à perturber sa grandeur physique CE, la grandeur physique présente d'importantes variations par rapport au niveau de référence variable REF, ces importantes variations étant très rapides dans le temps. C'est en comparant la valeur de la grandeur physique en la présence d'un objet O avec une valeur du niveau de référence REF, que le dispositif de détection CAPT peut en déduire la présence de cet objet O.

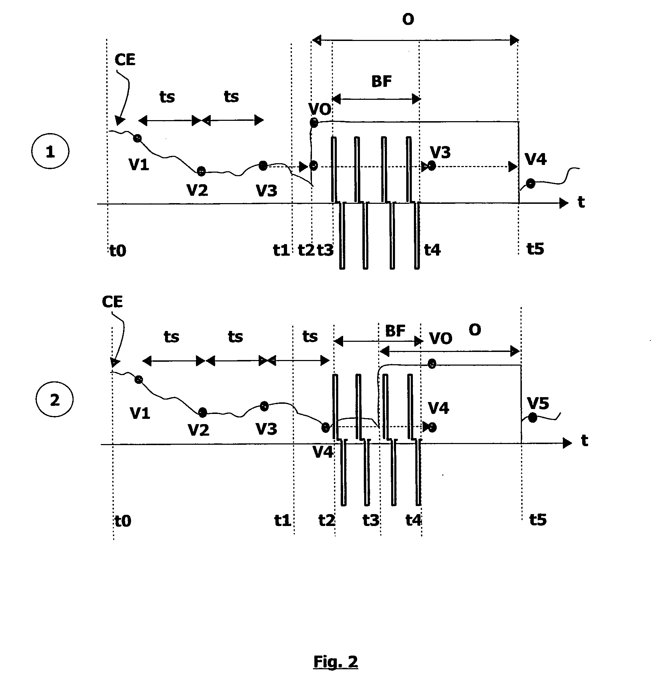

Deux exemples de variations d'une grandeur physique CE sont illustrés à la Fig. 2 dans lesquels :
- le premier diagramme de la Fig. 2 illustre la présence d'un objet O avant l'émission d'un signal basse fréquence BF et qui perdure après,
- le deuxième diagramme de la Fig. 2 illustre la présence d'un objet O pendant l'émission d'un signal basse fréquence BF et qui perdure après.

Le fonctionnement du dispositif de détection CAPT est décrit ci-après selon ces deux scénarios.

Concernant le premier diagramme de la Fig. 2 :
- Entre les temps t0 et t1, lorsqu'il n'y a pas d'objet O, la grandeur physique CE délivre un niveau de référence variable REF du fait de l'environnement de l'organe de détection EA/EB auquel elle est associée. Une valeur V de ce niveau de référence REF est mesurée et sauvegardée selon une période de temps ts déterminée (de l'ordre de quelques millisecondes dans un exemple non limitatif). Dans cet exemple, trois valeurs V1 à V3 ont été successivement sauvegardées, la dernière valeur V3 étant la plus récente. Elle remplace la précédente valeur V2 en mémoire.
- Au temps t2, lorsqu'un objet O s'approche d'un organe de détection EA/EB de telle manière qu'il perturbe son environnement, par exemple lorsqu'une main O d'un utilisateur coopère avec une poignée d'ouvrant P comportant ledit organe de détection EA/EB, la grandeur physique CE associée à l'organe de détection EA/EB varie également. Les variations sont plus importantes que les micro-variations citées précédemment.
Le dispositif de détection CAPT détecte ces variations en comparant la valeur mesurée de la grandeur physique CE en présence de l'objet O, la valeur VO illustrée sur le diagramme, avec la valeur du niveau de référence REF qui a été mesurée et sauvegardée en dernier avant la détection de la présence de l'objet O, soit ici la valeur V3. La comparaison indique la présence d'un objet O. A ce moment, on suspend l'auto-adaptation du niveau de référence REF de la grandeur physique CE de sorte que le niveau de référence REF soit figé et ne soit pas modifié par les mesures de la grandeur physique CE qui ne sont pas dues à l'environnement seul. Ainsi, aucune autre valeur V du niveau de référence REF n'est sauvegardée en mémoire.
- Au temps t3, un signal basse fréquence BF est émis. La valeur V3 du niveau de référence REF est toujours la dernière valeur sauvegardée en mémoire.
- Au temps t4, le signal basse fréquence BF n'est plus émis.
Dans ce cas, après l'émission du signal base fréquence BF, on libère la sauvegarde de la valeur du niveau de référence REF mesurée avant l'émission du signal basse fréquence BF. On ré-autorise ainsi l'auto-adaptation. L'auto-adaptation du niveau de référence REF n'est plus suspendue, le niveau de référence REF n'est plus figé. Cependant, comme l'objet O est toujours présent, il n'y a pas de nouvelle sauvegarde de valeur du niveau de référence REF.
La valeur V3 du niveau de référence REF étant toujours la valeur qui a été mesurée en l'absence d'objet O et avant l'émission du signal BF, le dispositif de détection CAPT détecte la présence de l'objet O après l'émission du signal basse fréquence BF, puisque la comparaison s'effectue entre la valeur mesurée VO de la grandeur physique CE au temps t4, soit en présence de l'objet O, et la valeur V3.
- Au temps t5, l'objet O ne se trouve plus en présence de l'organe de détection EA/EB, une nouvelle valeur du niveau de référence REF est sauvegardée, c'est la valeur V4. La valeur du niveau de référence REF mesurée avant l'émission d'un signal basse fréquence BF, et ici avant la détection de la présence d'un objet est ainsi remplacée par la nouvelle valeur V4.
Concernant le deuxième diagramme de la Fig. 2 :
- Entre les temps t0 et t2, lorsqu'il n'y a pas d'objet O, la grandeur physique CE délivre un niveau de référence variable REF du fait de l'environnement de l'organe de détection EA/EB auquel elle est associée. Une valeur V de ce niveau de référence REF est mesurée et sauvegardée selon une période de temps ts déterminée. Dans cet exemple, quatre valeurs V1 à V4 ont été successivement sauvegardées, la dernière valeur V4 étant la plus récente.
- Au temps t2, un signal basse fréquence BF est émis. A ce moment, l'auto-adaptation du niveau de référence REF est suspendue. Le niveau de référence REF est ainsi figé. La dernière valeur du niveau de référence sauvegardée en mémoire est donc la valeur V4 vue précédemment.
- Au temps t3, lorsqu'un objet O s'approche d'un organe de détection EA/EB de telle manière qu'il perturbe son environnement, par exemple lorsqu'une main O d'un utilisateur coopère avec une poignée d'ouvrant P comportant ledit organe de détection EA/EB, la grandeur physique CE associée à l'organe de détection EA/EB varie également. Les variations sont plus importantes que les micro-variations citées précédemment.

On notera que dans ce cas, le dispositif de détection CAPT ne détecte pas ces variations dans les deux cas suivants :
Dans le cas où le dispositif de détection CAPT est un dispositif capacitif (comprenant donc au moins un jeu d'électrode(s) comme organe de détection EA/EB) le signal basse fréquence BF peut le brouiller par couplage capacitif et/ou inductif empêchant le dispositif de détection CAPT d'effectuer une détection fiable de la présence d'un objet O.
Dans le cas où le dispositif de détection CAPT (qu'il soit ou non capacitif) comporte une alimentation commune avec l'antenne TX, son alimentation continue est coupée lors de l'émission du signal basse fréquence BF par l'antenne TX pour permettre l'alimentation de ladite antenne TX, ce qui l'empêche d'effectuer une détection de la présence d'un objet O, comme on va le voir en détail plus loin (sauf s'il est alimenté par la tension de résonance Vbf générée par ladite antenne TX).

- Au temps t4, le signal basse fréquence BF n'est plus émis. Le dispositif de détection CAPT n'est plus brouillé, ou son alimentation continue n'est plus coupée. Il peut ainsi fonctionner à nouveau.
   Dans ce cas, après l'émission du signal basse fréquence, on libère la sauvegarde de la valeur du niveau de référence REF mesurée avant l'émission du signal basse fréquence BF. On ré-autorise ainsi l'auto-adaptation. L'auto-adaptation du niveau de référence REF n'est plus suspendue, le niveau de référence REF n'est plus figé.
   Cependant, l'objet O est toujours présent dans le voisinage d'un organe de détection EA/EB de manière qu'il perturber sa grandeur physique CE associée, il n'y a donc pas de nouvelle sauvegarde de valeur du niveau de référence REF.
   La valeur V4 du niveau de référence REF étant toujours la valeur qui a été mesurée en l'absence d'objet O avant l'émission du signal BF, le dispositif de détection CAPT détecte la variation de la grandeur physique en comparant la valeur mesurée de la grandeur physique CE en présence de l'objet O, la valeur VO illustrée, avec cette valeur V4. La présence de l'objet O est ainsi toujours détectée après l'émission du signal basse fréquence BF.
- Au temps t5, l'objet O ne se trouve plus en présence de l'organe de détection EA/EB. Une nouvelle valeur du niveau de référence REF est sauvegardée, c'est la valeur V5.

Ainsi, dès lors que l'on détecte la présence d'un objet (par la mesure d'une grande variation de la grandeur physique CE) ou l'émission d'un signal basse fréquence BF, on suspend l'auto-adaptation du niveau de référence REF de la grandeur physique CE (la valeur du niveau de référence REF est figée) de telle sorte que la valeur du niveau de référence REF sauvegardée soit la valeur mesurée avant la détection d'un objet O ou avant l'émission d'un signal basse fréquence BF et ce pendant toute l'émission du signal basse fréquence BF au minimum, jusqu'à ce que :
- il n'y ait plus d'émission de signal basse fréquence BF, et
- ni de présence d'objet O au voisinage de l'organe de détection EA/EB qui perturbe la grandeur physique CE associée ou qu'il y ait un délai dépassé TIMEOUT (par exemple au-delà de 30 secondes). On notera que dans le cas d'un délai dépassé TIMEOUT, l'utilisateur doit retirer sa main et la remettre s'il veut de nouveau exécuter au moins une fonction de confort décrite plus loin.
On libère la sauvegarde après l'émission d'un signal basse fréquence. On ré-autorise l'auto-adaptation. Cependant, cette dernière ne sera exécutée (nouvelle sauvegarde d'une nouvelle valeur du niveau de référence REF) qu'en l'absence d'un objet O. Donc, tant que l'objet O demeure après l'émission d'un signal basse fréquence, il n'y a pas de nouvelle sauvegarde de valeur du niveau de référence REF (sauf en cas de TIMEOUT).

Ainsi, le niveau de référence REF n'est pas modifié par les mesures de la grandeur physique CE qui représentent des variations autres que celles de l'environnement seul (sans objet O) dans lequel se trouve l'organe de détection EA/EB.
De cette manière, le dispositif de détection CAPT peut détecter la présence d'une main qui coopère avec une poignée d'ouvrant de véhicule qui perdure après l'émission d'un signal basse fréquence BF (que la main ait commencé à coopérer avec la poignée d'ouvrant avant l'émission du signal basse fréquence BF ou pendant).
On notera que le dispositif de détection CAPT peut également détecter la présence d'une main qui a commencé à coopérer avec une poignée d'ouvrant de véhicule avant l'émission d'un signal basse fréquence BF et s'arrête de coopérer avec ladite poignée pendant ladite émission BF.

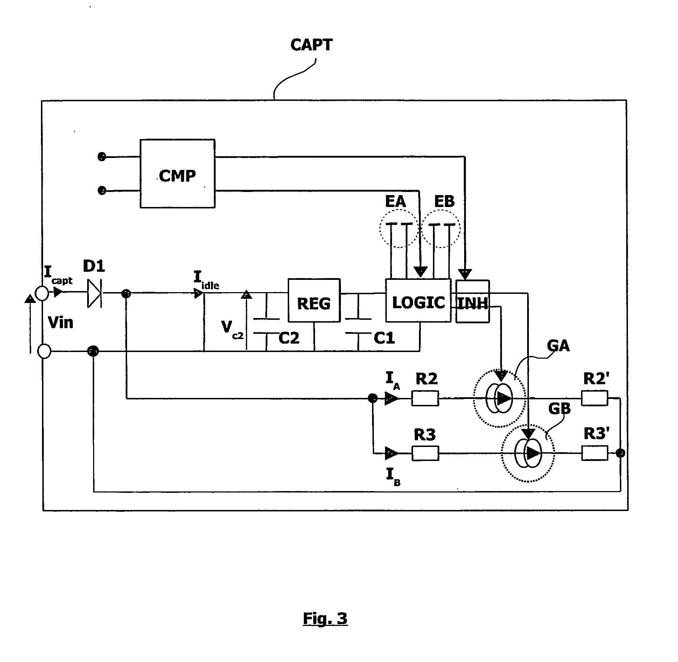

Le dispositif de détection CAPT est décrit plus en détail à la Fig. 3.

Outre les éléments décrits précédemment, le dispositif de détection CAPT comporte :
- au moins un moyen de mesure qui est dans un mode de réalisation non limitatif un générateur de courant GA/GB associé à l'organe de détection EA/EB, ici il y a deux générateurs de courant GA et GB associés respectivement aux deux organes de détection EA/EB ;
- un régulateur de tension REG pour réguler la tension du dispositif de sauvegarde LOGIC ;
- un condensateur d'entrée C2 pour emmagasiner l'énergie reçue de la tension d'entrée Vin et stabiliser la tension d'entrée du régulateur REG. Dans un exemple non limitatif, le dispositif d'entrée C2 est un condensateur ;
- un deuxième condensateur C1 pour stabiliser la tension de l'alimentation du dispositif de sauvegarde LOGIC et éviter ainsi les variations d'alimentation ;
- une première paire de résistance R2-R2' pour définir le courant I_{A} du premier générateur de courant GA.
- une deuxième paire de résistance R3-R3' pour définir le courant I_{B} du deuxième générateur de courant GB.

Le dispositif CAPT comprend en outre:
- un élément de détection basse fréquence CMP pour détecter le début d'une émission d'un signal basse fréquence BF ; et
- des moyens d'inhibition (INH) pour inhiber le moyen de mesure qui est ici un générateur de courant (GA/GB), de sorte que ledit moyen de mesure (générateur de courant (GA/GB)) ne génère plus de grandeur électrique de sortie, soit ici de courant de sortie générateur (I_{A}-I_{B}).

Lorsque l'unité de détection PSU est alimentée en tension par la tension d'entrée Vin illustré à la Fig. 1 et à la Fig. 3, il consomme un courant commun Ipsu illustré à la Fig. 1 et à la Fig. 3 également. Ce courant commun Ipsu est réparti :
- en un courant d'antenne Iₜₓ circulant dans l'antenne basse fréquence TX ;
- en un courant capteur I_{CAPT} se répartissant lui-même en deux courants de sortie générateurs I_{A} et/ou I_{B} générés respectivement par les générateurs GA et GB quand ils sont actifs ; et
- en un courant de veille I_{IDLE} pour alimenter le régulateur REG et le dispositif de sauvegarde LOGIC. On notera que ce courant de veille I_{IDLE} est nettement inférieur au deux courants de sortie générateurs I_{A} et I_{B}.

Lorsque la tension d'entrée Vin alimente le dispositif CAPT, elle est sous forme d'une tension continue, de 12V par exemple, ledit dispositif CAPT nécessitant une alimentation continue. Le dispositif CAPT étant alimenté, il permet une détection de la présence d'une main d'un utilisateur coopérant avec une poignée P d'ouvrant de véhicule V.
La main d'un utilisateur peut coopérer avec une poignée P selon différentes manières qui sont les suivantes :
- soit la main est placée dans la poignée P (jeu d'électrode(s) EA activée) ;
- soit la main se trouve sur la poignée P, elle est donc en contact avec cette dernière (jeu d'électrode(s) EB activée).
Quand il existe une telle détection de la présence d'une main d'un utilisateur coopérant avec une poignée P, le générateur de courant du dispositif CAPT associé GA et/ou GB au jeux d'électrode(s) EA et/ou EB qui est activée est actif. Un courant de sortie générateur I_{A}/I_{B} respectivement associé à chaque générateur de courant GA/GB actif est ainsi généré lors de l'activation du jeu d'électrode(s) EA/EB associé.

Le courant général d'alimentation commun Ipsu est alors égal à la somme des courants de sortie générateurs I_{A} et/ou I_{B} générés plus le courant de veille I_{IDLE}. On rappelle que le courant Ipsu (donc I_{A} et/ou I_{B}) permet au contrôleur ECU du véhicule V de vérifier qu'il existe une présence de main coopérant avec une poignée P.
En effet, le contrôleur du véhicule ECU permet de mesurer ce courant commun Ipsu consommé et de déterminer selon sa valeur si :
- 1) une main se trouve dans la poignée P, que ce soit avec ou sans contact (Ipsu = I_{A} +I_{IDLE}) ;
- 2) une main se trouve sur la poignée P (Ipsu = I_{B}+ I_{IDLE});
- 3) une main se trouve dans la poignée P et est sur la poignée également (Ipsu = I_{A}+I_{B}+ I_{IDLE}) ;
- 4) l'absence de main (Ipsu = I_{IDLE}).
En fonction de la mesure du courant commun Ipsu, le contrôleur ECU permet alors d'effectuer une commande sur la serrure du véhicule correspondant à la détection effectuée, à savoir :
- déverrouillage de la serrure dans le premier cas 1);
- verrouillage de la serrure dans le deuxième cas 2);
- déterminer la priorité entre déverrouillage et verrouillage de la serrure dans le troisième cas 3) et commande associée à la fonction prioritaire ;
- ne rien effectuer dans le dernier cas.
Les moyens de mesure, dans l'exemple pris, les générateurs de courant GA/GB, permettent ainsi de donner des informations sur les états des organes de détection EA/EB (activé ou non).

De plus, selon la durée avec laquelle la main coopère avec une poignée P, le contrôleur ECU va pouvoir exécuter au moins une fonction de confort décrite plus loin.
L'antenne TX émet un signal basse fréquence BF pour permettre l'identification/authentification de l'objet identifiant ID détenu par l'utilisateur et permettre un accès au véhicule (que cette émission soit déclenchée après la détection d'une main, ou soit faite de manière continue par une méthode de « polling » en anglais). On rappelle que l'identification d'un objet d'identification ID permet de connaître son numéro de série, et l'authentification, qu'elle soit simple (effectuée par l'objet d'identification) ou mutuelle (effectuée par l'objet d'identification et le véhicule) permet quant à elle de vérifier que l'objet d'identification ID a les droits d'accès au véhicule, une authentification se faisant au moyen d'un cryptage.
Afin de fonctionner, l'antenne TX est alimentée en tension par la tension d'entrée Vin. A cet effet, la tension d'entrée Vin devient un signal pulsé, de -12V/0V/+12V par exemple. Dans d'autres exemples non limitatifs, on peut avoir 0V/12V ou -12V/0V. L'antenne TX qui comporte un circuit résonnant LC transforme ce signal pulsé Vin en un champ magnétique de sorte à communiquer avec l'objet d'identification ID (via un signal résonnant Vbf).

Le fonctionnement du dispositif de détection CAPT est décrit plus en détail dans le cadre de différents modes de réalisation décrits ci-après.
Dans la suite de la description, on prend comme exemple non limitatif, un dispositif de détection CAPT capacitif et des jeux d'électrode(s) comme organes de détection. De plus, la présence d'un objet O tel qu'un main d'un utilisateur d'un véhicule automobile qui coopère avec une poignée d'ouvrant du véhicule est toujours considéré comme exemple non limitatif.

Le premier jeu d'électrode(s) EA, dit d'approche, permet de détecter la présence d'une main dans une poignée P, que ce soit avec ou sans contact, pour effectuer le déverrouillage d'un ouvrant.
Le deuxième jeu d'électrode(s) EB, dit tactile, permet de détecter la présence d'une main sur la poignée P pour effectuer le verrouillage d'un ouvrant, en général lorsque par exemple la main se trouve sur un endroit spécifique de la poignée à l'extérieur de ladite poignée. Dans un mode de réalisation non limitatif, un jeu d'électrode(s) comporte deux électrodes EA1, EA2 et EB1 EB2, la première étant une électrode d'excitation tandis que la deuxième est une électrode de mesure. La première électrode émet un signal d'excitation. Des lignes de champ entre les deux électrodes sont créées et le signal obtenu par couplage capacitif et/ou inductif entre la première électrode et la deuxième électrode est mesuré (par le circuit intégré de commande LOGIC). Ainsi, quand une main est introduite dans la poignée P sans contact ou entre en contact avec la poignée P, la capacité entre les deux électrodes diminue rapidement. En effet, les lignes de champ varient en présence de la main (certaines lignes de champ sont déviées vers la main qui peut être considérée comme la masse).
Dans un deuxième mode de réalisation non limitatif, un jeu d'électrode comporte une seule électrode qui est utilisée avec une masse. Dans ce cas, c'est la capacité entre cette électrode et la masse qui est mesurée. Dans ce cas, au contraire, la capacité augmente rapidement en présence de la main.
L'utilisation de tels jeux d'électrode(s) étant bien connue de l'homme du métier, elle n'est pas décrite plus en détail ici.

### Premier mode de réalisation

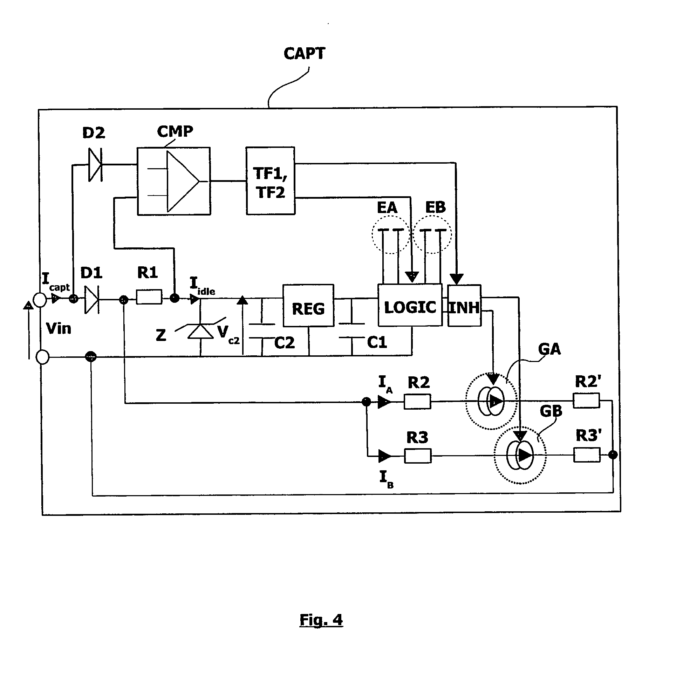

Un premier mode de réalisation du dispositif de détection CAPT est illustré à la Fig. 4.
Selon ce premier mode de réalisation, outre les caractéristiques décrites ci-dessus :
- a) l'antenne TX et le dispositif de détection CAPT ont une alimentation commune ;
- b) l'élément de détection basse fréquence CMP est un comparateur pour comparer la tension Vc2 aux bornes de son condensateur d'entrée C2 et la tension d'entrée Vin.
Dans une variante de réalisation non limitative, le comparateur CMP est un comparateur à hystérésis.
- c) les moyens d'inhibition INH inhibent un générateur de courant GA/GB lorsque la tension d'entrée Vin est inférieure à la tension Vc2 aux bornes du condensateur d'entrée C2 moins un premier seuil Vs1.

Dans un mode de réalisation non limitatif, outre les caractéristiques décrites précédemment, le dispositif CAPT comprend en outre :
- un premier filtre temporel TF1 pour mesurer la durée T_{C} de la coupure d'alimentation continue et n'autoriser :
   - la sauvegarde de la valeur du niveau de référence REF mesurée avant l'émission du signal basse fréquence BF que si ladite durée T_{C} est supérieure à un premier temps prédéterminé Tp1, et
   - l'inhibition d'un (des) générateur(s) de courant GA/GB qui est (sont) actif(s) que si ladite durée T_{C} est supérieure à un premier temps prédéterminé Tp1 ; et
- un deuxième filtre temporel TF2 pour :
   - libérer la sauvegarde de la valeur du niveau de référence REF mesurée avant l'émission du signal basse fréquence BF, lorsque la tension d'entrée Vin est égale à la tension Vc2 aux bornes du condensateur d'entrée C2 pendant une durée Tp2 supérieure à un deuxième temps prédéterminé T_{BF} ; et
   - désinhiber un (des) générateur(s) de courant qui a été inhibé, lorsque la tension d'entrée Vin est égale à la tension Vc2 aux bornes du condensateur d'entrée C2 pendant une durée Tp2 supérieure à un deuxième temps prédéterminé T_{BF}.

Dans un exemple non limitatif, le premier temps prédéterminé Tp1 est supérieur à une micro-coupure d'alimentation. En pratique, comme on va le voir plus loin, on regarde si la sortie S_CMP de l'élément de détection basse fréquence CMP est activée pendant le premier temps prédéterminé Tp1.

Dans un exemple non limitatif, le deuxième temps prédéterminé T_{BF} est une période d'émission d'un signal basse fréquence ou un multiple de cette période.
Dans une variante de réalisation, le deuxième filtre TF2 libère la sauvegarde lorsque la tension d'entrée Vin est supérieure à la tension Vc2 aux bornes de son condensateur d'entrée C2 moins un deuxième seuil Vs2 pendant une durée Tp2 supérieure au deuxième temps prédéterminé T_{BF.}
On notera que par libération de la sauvegarde, on entend que le deuxième filtre temporel TF2 ré-autorise une auto-adaptation du niveau de référence de l'organe de référence EA/EB associé. L'auto-adaptation n'est ainsi plus suspendue.

On notera qu'un seul filtre temporel TF peut effectuer les deux filtrages exposés ci-dessus.
Par ailleurs, dans un mode de réalisation non limitatif, on peut prendre le premier intervalle de temps Tp1 égal au deuxième intervalle de temps Tp2. Cela permet de simplifier le filtrage temporel et de simplifier la conception du (des) filtre(s) temporel(s).

Enfin, le dispositif de détection CAPT comporte en outre :
- une diode Zener Z pour protéger la tension du régulateur de tension REG et éviter ainsi les surtensions ;
- une première résistance R1 pour limiter le courant consommé dans la diode Zener Z en cas de surtension de la tension d'entrée Vin et dans le condensateur d'entrée C2 à la mise sou tension du dispositif de détection CAPT;
- Une première diode D1 en série avec le régulateur REG pour le protéger contre les inversions de tension d'entrée Vin ; et
- une deuxième diode D2 en série avec l'élément de détection basse fréquence CMP de début d'émission d'un signal basse fréquence pour le protéger contre les inversions de tension d'entrée Vin.

Le dispositif de détection de présence CAPT selon ce premier mode de réalisation décrit fonctionne de la manière suivante.

Comme on va le voir ci-après, la comparaison entre la tension d'entrée Vin et la tension Vc2 aux bornes du condensateur d'entrée C2 va permettre de détecter une coupure de l'alimentation continue dudit dispositif CAPT. On notera que cette comparaison est effectuée de façon continue ou discrète (par échantillonnage).
Le début de l'émission d'un signal basse fréquence est ainsi détecté (que cette émission soit déclenchée par la détection d'une main ou par une méthode de « polling »).
En effet, l'alimentation continue du dispositif CAPT est coupée car la tension d'entrée Vin n'est plus continue. C'est une tension pulsée qui permet à l'antenne TX de fonctionner. On rappelle que dans ce mode de réalisation, l'antenne TX et le dispositif de détection CAPT comporte une alimentation commune.

A ce moment, lorsqu'une telle coupure d'alimentation continue est détectée, la valeur du niveau de référence REF de la grandeur physique CE de l'organe de détection EA/EB associé va être figée. De plus, les générateurs de courant GA et/ou GB qui sont actifs vont être inhibés.

Cela va permettre notamment la détection de la présence d'une main qui :
- a commencé à coopérer avec une poignée P pendant l'émission du signal basse fréquence BF et continue de coopérer après ; et
- a commencé à coopérer avec une poignée P avant l'émission du signal basse fréquence BF et continue de coopérer après.

On va ainsi pouvoir détecter la présence d'une main qui coopère longtemps avec une poignée P, c'est-à-dire au delà de l'émission du signal basse fréquence.

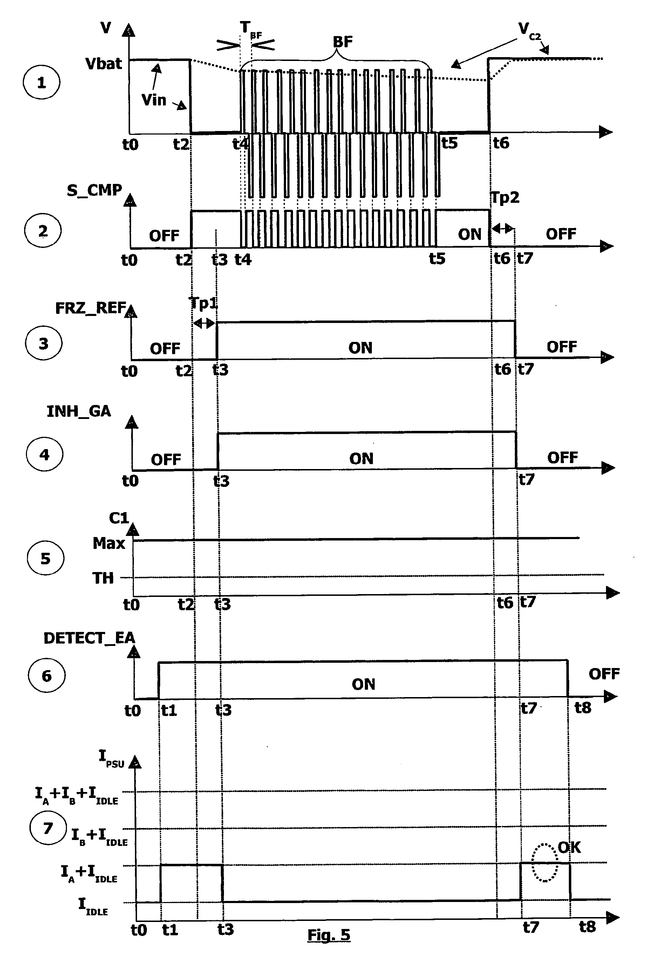

Les diagrammes de la Fig. 5 permettent d'expliquer plus en détail le fonctionnement du dispositif de détection CAPT selon ce premier mode de réalisation.
On notera que sur la Fig. 5, la tension d'excitation d'antenne qui est ici la tension d'entrée Vin correspond à l'émission du signal base fréquence BF.
- Au temps t0 de l'exemple de la Fig. 5, on se place dans le cas où il n'y a pas de main qui coopère avec une poignée P d'ouvrant du véhicule V.
Le dispositif CAPT est alimenté en tension par la tension d'entrée Vin qui est illustrée à la Fig. 5 sur le premier diagramme. Le dispositif CAPT est inactif (il n'y pas de présence de main et il est alimenté en tension Vin).
Au temps t0, cette tension d'entrée Vin est à une tension de 12 V dans l'exemple pris correspondant à la tension batterie Vbat.
Le condensateur d'entrée C2 emmagasine de l'énergie donnée par cette tension d'entrée Vin qui alimente le dispositif CAPT et il se charge. Sa tension Vc2 augmente donc jusqu'à la tension d'entrée Vin. Sur le premier diagramme de la Fig. 5, Vc2 = Vin.

Le deuxième condensateur C1 se charge également jusqu'à son maximum Max comme illustré sur le cinquième diagramme de la Fig. 5.
On notera que la tension Vc2 du condensateur d'entrée C2 est donc représentatives de la tension d'entrée du dispositif CAPT.

Quant au courant commun Ipsu consommé par l'unité de détection de présence PSU, il est égal au courant de veille I_{IDLE}, comme illustré sur le septième diagramme de la Fig. 5 (aucun générateur de courant GA/GB n'étant actif, donc aucun courant de sortie générateur I_{A}/I_{B} n'étant généré).
- Au temps t1, l'utilisateur met sa main dans une poignée P d'ouvrant du véhicule V. Le dispositif CAPT détecte la présence d'un changement de capacité dans la poignée P via l'organe de détection EA. Il devient donc actif ainsi que le premier générateur de courant GA (état ON), comme on peut le voir sur le sixième diagramme DETECT_EA de la Fig. 5.

A ce moment, le courant commun Ipsu consommé par l'unité de détection de présence PSU est alors égal au courant de sortie générateur I_{A} généré par le générateur de courant actif GA, et au courant de veille I_{IDLE}, comme illustré sur le septième diagramme de la Fig. 5.
- Au temps t2, à la suite d'une détection da la présence d'une main d'un utilisateur qui coopère avec une poignée P, la tension d'entrée Vin devient un signal pulsé afin de permettre une alimentation de l'antenne TX pour qu'elle puisse émettre un signal basse fréquence BF. On s'est placé dans cet exemple dans le cas où la détection d'une main déclenche l'émission d'un signal basse fréquence BF. Bien entendu, le même principe peut s'appliquer en cas de « polling ».

La tension d'entrée Vin chute donc à zéro pendant un intervalle de temps t2-t4 équivalent au temps de déclenchement de l'émission d'un signal basse fréquence BF par l'antenne TX.
L'alimentation continue du dispositif CAPT est donc coupée.
Lorsque le dispositif CAPT n'est plus alimenté, il est désactivé et devient autonome, c'est-à-dire qu'il comporte encore suffisamment d'énergie pour faire une détection de présence.
Le condensateur d'entrée C2 commence à se décharger (sa tension Vc2 commence a diminuer progressivement) comme illustré sur le premier diagramme.

A ce moment, le comparateur CMP observe une différence de tension entre la tension d'entrée Vin et la tension Vc2 aux bornes du condensateur d'entrée C2 du dispositif CAPT.
Lorsque la différence de tension est telle que la tension d'entrée Vin est inférieure à la tension Vc2 aux bornes du condensateur d'entrée C2 moins un premier seuil Vs1, la sortie S_CMP du comparateur CMP est mis à 1 (état ON), au temps t2 telle qu'illustrée sur le deuxième diagramme de la Fig. 5.
On notera que ce premier seuil de tension Vs1 suit les variations de la tension Vc2 du condensateur d'entrée C2 (lorsqu'il se charge et se décharge). Ce premier seuil de tension Vs1 est défini de sorte qu'il est supérieur à des signaux parasites sur la tension d'entrée Vin, ces signaux parasites pouvant entraîner des ondulations sur ladite tension d'entrée Vin. Ainsi, cela permet au comparateur CMP de ne pas prendre en compte ces ondulations.
- Lorsqu'une telle différence de tension est ainsi constatée, on suspend l'auto-adaptation du niveau de référence REF du dispositif CAPT, tel qu'illustré sur le troisième diagramme nommé FRZ_REF de la Fig. 5 (état ON).
La valeur du niveau de référence REF de la capacité du jeu d'électrodes EA est figée comme expliqué précédemment. C'est-à-dire que la dernière valeur du niveau de référence REF qui est sauvegardée en mémoire est la valeur du niveau de référence mesurée avant l'émission d'un signal basse fréquence BF, soit ici avant la coupure d'alimentation continue du dispositif de détection CAPT.
La configuration du dispositif CAPT est ainsi gelée.

Au temps t3, dans un mode de réalisation non limitatif tel qu'illustré sur le troisième diagramme de la Fig. 5, on suspend l'auto-adaptation du niveau de référence REF lorsque la sortie S_CMP du comparateur CMP est activée (ON) après un intervalle de temps Tp1 supérieur à une micro-coupure de tension, de sorte que le niveau de référence REF soit figé. Cela permet de ne pas confondre entre une micro-coupure et une véritable coupure d'alimentation du dispositif CAPT, et par conséquent de ne pas figer la valeur du niveau de référence REF à chaque fois qu'il y a une micro-coupure. Ainsi, on évite de figer l'auto-adaptation pour rien. On rappelle qu'une micro-coupure peut être due par exemple à une perturbation électromagnétique ou peut être due à un problème de connectique (faux contact sur un connecteur).

On notera que l'émission d'un signal basse fréquence BF par l'antenne TX provoque ainsi une différence de tension entre la tension d'entrée Vin et la tension Vc2 du condensateur C2 d'entrée comme expliqué précédemment.
Or, dans le cas où le dispositif CAPT est un dispositif capacitif, même si le dispositif CAPT reste suffisamment alimenté (C1 et C2 suffisamment chargées) lorsqu'il n'a plus d'alimentation continue de la part de la tension d'entrée générale Vin, c'est-à-dire qu'il est autonome (le dispositif CAPT peut encore détecter la présence d'une main qui coopère avec une poignée P), une telle émission BF brouille ledit dispositif en raison d'un couplage capacitif et/ou inductif parasite entre l'antenne TX et ledit dispositif de détection capacitif CAPT. L'antenne TX étant à proximité du dispositif détection CAPT (en général les deux éléments étant dans la poignée), il existe en effet un tel couplage capacitif et/ou inductif parasite. Ceci peut entraîner une variation importante du niveau de référence REF lorsque le dispositif CAPT est autonome et également des mauvaises/fausses détections de présence d'une main de l'utilisateur coopérant avec une poignée P de véhicule V.
On rappelle qu'une mauvaise détection est le fait de ne pas détecter la présence d'une main alors qu'il existe une telle main qui coopère avec une poignée P, tandis qu'une fausse détection est le fait de détecter la présence d'une main qui coopère avec une poignée, alors que ce n'est pas le cas.

Le fait de figer la valeur du niveau de référence REF du dispositif CAPT pendant l'émission d'un signal basse fréquence BF permet donc d'éviter ses variations de référence et des mauvaises/fausses détections. Cela permet donc de s'immuniser contre les perturbations engendrées par l'émission d'un signal basse fréquence BF pour le dispositif de détection capacitif.

On notera que comme le dispositif CAPT n'est plus alimenté en tension, il faut éviter qu'il ne tire du courant sinon les condensateurs C1 et C2 vont se décharger. On veut en effet qu'il demeure autonome afin de pouvoir sauvegarder sa valeur du niveau de référence REF. On inhibe donc le générateur de courant qui est actif, le générateur GA dans l'exemple pris, de sorte que ce dernier ne puisse plus générer de courant de sortie générateur I_{A}. Une telle inhibition est illustré à la Fig. 5 sur le quatrième diagramme INH_GA (état ON). Cette opération d'inhibition est effectuée, lorsqu'une coupure d'alimentation du dispositif de détection CAPT est constatée, comme dans le cas où l'on a figé la valeur du niveau de référence REF.

Afin d'inhiber un générateur de courant, dans des exemples on limitatifs :
- soit on désactive la sortie en courant (état de la sortie à 0) du dispositif CAPT correspondant au générateur de courant qui est actif (ici le générateur GA). Cette désactivation est effectuée de manière logique par le circuit intégré de commande LOGIC, les moyens d'inhibition INH étant ici le circuit de commande LOGIC ;
- soit on coupe l'alimentation du générateur de courant lui-même, celui qui est actif (ici le générateur GA). Dans un exemple non limitatif, les moyens d'inhibition INH peuvent être un transistor TR2 qui vient tirer à la masse la commande du générateur de courant GA. En pratique, dans le cas d'un jeu d'électrodes à deux électrodes, on met l'électrode de mesure à la masse. On fige ainsi son potentiel à zéro. On force ainsi la mesure capacitive à zéro.

Ainsi, du fait de l'inhibition du générateur de courant GA, le courant commun Ipsu est égal au courant de veille I_{IDLE} uniquement, comme on peut le voir sur le septième diagramme de la Fig. 5 au temps t3. Le générateur de courant GA n'est donc plus actif.

Une telle inhibition évite que les condensateurs C1 et C2 ne se déchargent quand il n'existe plus de tension d'entrée Vin alimentant le capteur CAPT.

Dans un mode de réalisation non limitatif tel qu'illustré sur le quatrième diagramme de la Fig. 5, comme dans le cas où l'on fige la valeur du niveau de référence REF, on inhibe le générateur de courant GA lorsque la sortie S_CMP du comparateur CMP est activée (ON) après un premier intervalle de temps Tp1 supérieur à une micro-coupure de tension. Cela permet de ne pas confondre entre une micro-coupure et une véritable coupure d'alimentation du dispositif CAPT, et par conséquent de ne pas inhiber le générateur de courant à chaque fois qu'il y a une micro-coupure. Ainsi, on évite d'effectuer une inhibition pour rien.

On peut voir qu'au temps t3, le premier condensateur C1 ne se décharge pas tel qu'illustré sur le cinquième diagramme de la Fig. 3. En effet, le condensateur C2 ne se décharge pas suffisamment pour qu'il puisse se décharger lui-même (le condensateur C2 peut se décharger tout de même encore un peu, mais ceci est dû au fait que le dispositif de sauvegarde LOGIC et le régulateur REG consomment un peu d'énergie pour leurs besoins propres, et non pas le générateur de courant GA), voire le condensateur C2 peut se recharger légèrement par la tension d'excitation d'antenne Vin.

On notera que entre le temps t2 et le temps t3, c'est-à-dire entre la coupure de l'alimentation continue du dispositif CAPT et le gel de sa configuration, le condensateur C2 du dispositif CAPT se décharge un peu, comme on peut le voir sur le premier diagramme de la Fig. 5, mais pas suffisamment pour que le dispositif de détection CAPT se réinitialise et perde sa valeur de niveau de référence REF sauvegardée auparavant.
On remarquera par ailleurs que le premier intervalle de temps tp1 est inférieur au temps de déclenchement entre t2 et t4 de l'émission d'un signal basse fréquence BF ; sinon, la valeur du niveau de référence REF serait perturbée par le couplage existant entre l'antenne TX et les organes de détection EA/EB du dispositif de détection CAPT.
- Au temps t4, à la suite de la détection de présence d'une main, le signal basse fréquence BF est donc émis par l'antenne TX afin d'interroger l'objet d'identification ID détenu par l'utilisateur du véhicule et vérifier qu'il est bien associé audit véhicule V et permettre ainsi son accès. En retour, l'objet d'identification ID enverra une réponse radio-fréquence RF sur une fréquence typique (non limitative) de 433 MHz comprenant un code objet d'identification permettant son identification et des données de cryptage permettant son authentification pour permettre un accès véhicule par la suite.

On notera que le renvoi de la réponse radio-fréquence RF, se fait avant que l'utilisateur ne tire sur la poignée P du véhicule V pour l'ouvrir.
Le signal basse fréquence BF est émis pendant un intervalle de temps t4-t5 avec une période T_{BF} définie de quelques micro-secondes en général correspondant typiquement à 125kHz. Bien entendu, d'autres fréquences peuvent être utilisées.
L'antenne TX fonctionnant sur une tension non continue pulsée, de -12V/0V/12V dans l'exemple pris, comme on peut le voir sur le premier diagramme de la Fig. 5, à ce moment, la tension d'entrée Vin devient une telle tension pulsée.

Lors de l'émission d'un signal basse fréquence BF, à ce moment, le comparateur CMP détecte toujours les différences de tension entre la tension d'entrée Vin et la tension Vc2 aux bornes du condensateur d'entrée C2 du dispositif CAPT.
La tension d'entrée Vin variant de 12V à 0V à -12V, la sortie S_CMP du comparateur CMP est donc à l'état 1 (ou ON) lorsque Vin = 0 ou Vin = -12V, et à l'état 0 (ou OFF) lorsque Vin = 12V, comme on peut le voir dans l'exemple sur le deuxième diagramme de la Fig. 5.

Le niveau de référence REF du dispositif CAPT est toujours figée (ON) et le dispositif CAPT est toujours autonome (ON) (pas de tension d'entrée Vin et générateur de courant GA inhibé) comme on peut le voir respectivement sur le troisième et quatrième diagramme de la Fig. 5.
- Au temps t5, l'antenne TX ayant terminé d'émettre le signal basse fréquence BF, on peut de nouveau réalimenter le dispositif CAPT avec la tension d'entrée Vin au temps t6 après un temps de latence. Cette dernière redevient continue, et égale à 12V dans l'exemple pris, comme on peut le voir sur le premier diagramme de la Fig. 5. Il n'y a donc plus de coupure d'alimentation continue.

La sortie S_CMP du comparateur CMP, illustrée sur le deuxième diagramme de la Fig. 5, est de nouveau égale à 0 (état OFF), puisque la tension d'entrée continue Vin est supérieure à la tension du dispositif Vc2.
Le dispositif CAPT étant réalimenté, ses condensateurs C1 et C2 se rechargent jusqu'à sa tension de régulation MAX et la tension d'entrée Vin respectivement, comme on peut le voir respectivement sur le cinquième et premier diagrammes de la Fig. 5.
Lorsqu'il n'existe plus de coupure d'alimentation continue du dispositif de détection CAPT, on peut :
- libérer la sauvegarde de la valeur du niveau de référence qui a été mesurée avant l'émission BF, c'est-à-dire permettre de nouveau l'auto-adaptation (qui se fera en l'absence de main), et
- réactiver (désinhiber) le(s) générateur(s) de courant GA/GB qui a été (ont) inhibé(s), ici le générateur GA.

Dans une variante de réalisation, on notera que bien que le dispositif CAPT soit de nouveau réalimenté (la tension du condensateur d'entrée Vc2 se recharge jusqu'à la tension d'entrée Vin), on ne réactive pas de suite le générateur de courant GA qui a été inhibé et on ne libère pas de suite la sauvegarde de la valeur du niveau de référence qui a été mesurée avant l'émission BF, c'est-à-dire qu'on ne permet pas de suite l'auto-adaptation du niveau de référence REF du jeu d'électrode EA.
En effet, lors d'une émission d'un signal basse fréquence BF par l'antenne TX, la tension d'entrée Vin pulsée varie de -12V à 0V à +12V comme vu précédemment. Or la sortie S_CMP du comparateur CMP montre également cette variation avec la tension Vc2 comme expliqué précédemment. Il y a donc un risque de considérer l'émission basse fréquence BF comme une réalimentation du dispositif CAPT (lorsque la tension d'entrée Vin pulsée égale +12V), alors que ce n'est pas le cas.
- Pour éviter ce risque, le deuxième filtre temporel TF2 libère la sauvegarde de la valeur du niveau de référence REF mesurée avant l'émission du signal basse fréquence BF, c'est-à-dire qu'il ré-autorise l'auto-adaptation du niveau de référence REF, lorsque la tension d'entrée Vin est supérieure à la tension Vc2 aux bornes du condensateur d'entrée C2 moins un deuxième seuil Vs2 pendant un deuxième intervalle de temps Tp2 supérieur à la période d'émission T_{BF} d'un signal basse fréquence BF par l'antenne TX ,ou ce qui est équivalent, lorsque la sortie S_CMP du comparateur CMP est activée (état ON) pendant un deuxième intervalle de temps Tp2 supérieur à la période d'émission T_{BF} d'un signal basse fréquence BF par l'antenne TX. Ceci est donc fait au temps t7, comme on peut le voir sur le troisième diagramme FRZ_REF de la Fig. 5.

Au temps t7, on ré-autorise donc au dispositif de détection CAPT d'auto-adapter de nouveau le niveau de référence REF correspondant au jeu d'électrodes EA (qui se fera en l'absence de main).
On notera que la valeur du niveau de référence REF qui a été mesurée avant l'émission du signal basse fréquence BF et plus particulièrement avant la coupure d'alimentation continue du dispositif de détection CAPT est ici toujours la valeur qui est sauvegardée, car la main est toujours détectée au temps t7 (sixième diagramme DETECT_EA de la Fig. 5). L'auto-adaptation ne se fera en réalité que lorsque la main sera de nouveau absente.

Le deuxième filtre temporel TF2 permet ainsi de filtrer les fréquences d'émission du signal basse fréquence BF.

Pour les mêmes raisons, le deuxième filtre temporel TF2 réactive le générateur de courant GA qui a été inhibé :
- soit en réactivant la sortie en courant I_{A} du dispositif CAPT (du générateur de courant GA dans l'exemple pris) ;
- soit en réactivant son alimentation
lorsque la tension d'entrée Vin est supérieure à la tension Vc2 aux bornes du condensateur d'entrée C2 moins un deuxième seuil Vs2 pendant un deuxième intervalle de temps Tp2 supérieur à la période d'émission T_{BF} d'un signal basse fréquence BF par l'antenne TX.

Ceci est donc fait au temps t7, comme on peut le voir sur le quatrième diagramme INH_GA de la Fig. 5.
On lui permet de générer de nouveau du courant I_{A}.
Les deux condensateurs C1 et C2 se rechargent donc au maximum jusqu'à la tension Max et la tension d'entrée Vin respectivement, comme illustré respectivement sur le cinquième (condensateur C1) et le premier (tension Vc2 illustrée) diagrammes de la Fig. 5.
Le courant commun Ipsu est donc de nouveau égal au courant de veille I_{IDLE} et au courant I_{A} circulant dans le générateur de courant actif GA.

La mesure du courant commun Ipsu par le contrôleur du véhicule ECU qui sert à voir si le dispositif CAPT est actif ou non, permet de voir qu'il est toujours actif, c'est-à-dire qu'il existe toujours la présence d'une main qui coopère avec la poignée P quand le dispositif CAPT est alimenté par la tension d'entrée Vin.
Ainsi, même si l'utilisateur du véhicule V à laissé longtemps sa main dans (avec ou sans contact) ou sur la poignée P (donc avec contact), c'est-à-dire au-delà de l'émission du signal basse fréquence BF, cette présence de main est toujours détectée par le dispositif CAPT. On évite ainsi de perdre l'information présence de main coopérant avec la poignée P après l'émission du signal basse fréquence BF. Le fait de détecter une coopération main-poignée qui dure après l'émission d'un signal basse fréquence BF (que l'on nomme souvent appui long) permet ainsi d'activer des fonctions de confort telles que, dans des exemples non limitatifs :
- remonter les vitres du véhicule jusqu'à ce que la main ne coopère plus avec la poignée P ;
- remonter la capote d'une voiture décapotable ;
- activer l'alarme du véhicule ; et
- super-condamner le véhicule, c'est-à-dire débrayer les poignées intérieures après un verrouillage des portes du véhicule (cela empêche un voleur d'ouvrir le véhicule de l'intérieur à l'aide des poignées après qu'il a cassé une vitre par exemple) etc.

Dans un exemple non limitatif, cet « appui long » peut durer jusqu'à 30 secondes.
- Au temps t8, l'utilisateur du véhicule V sort sa main de la poignée P du véhicule V comme illustré sur le sixième diagramme DETECT_EA de la Fig. 5 (état OFF). Le générateur de courant GA n'est plus actif (état OFF), il n'y a plus de courant I_{A} qui circule. Le courant commun Ipsu devient égal au courant de veille I_{IDLE} uniquement.
La mesure du courant commun Ipsu par le contrôleur du véhicule ECU permet de voir que le dispositif de détection CAPT n'est plus actif, c'est-à-dire qu'il n'y a pas de présence de main qui coopère avec la poignée P considérée.

Ainsi, le dispositif CAPT décrit permet de déterminer la présence de la main d'un utilisateur de véhicule V coopérant avec une poignée P qui dure longtemps contrairement à l'art antérieur. Dans le cas d'un dispositif selon l'art antérieur, lors d'une présence « longue » illustrée sur le deuxième diagramme de la Fig. 6 au temps t7 à t12 par exemple, le condensateur C1 se décharge complètement au temps t11 sur le troisième diagramme de la Fig. 6 (ainsi que le condensateur d'entrée C2) entraînant une désactivation du dispositif de détection CAPT et une réinitialisation (« reset » en anglais) dudit dispositif CAPT. Par conséquent son dispositif de sauvegarde LOGIC est réinitialisé ce qui entraîne une perte de la valeur du niveau de référence REF qui a été sauvegardée auparavant.
Le dispositif CAPT se réinitialise donc à la valeur du niveau de référence REF qu'il mesure, qui correspond à celle d'une main coopérant avec une poignée P. Il ne détecte donc plus la main coopérant avec une poignée P puisqu'il va comparer deux valeurs identiques.
Le courant commun Ipsu est à ce moment égal au courant de veille I_{IDLE}.
La mesure de ce courant indique donc qu'aucun générateur de courant GA/GB n'est actif alors qu'il existe une présence de main qui coopère avec une poignée, le générateur de courant GA devant être actif dans l'exemple pris.

Ainsi, le dispositif de détection DETECT selon ce premier mode de réalisation présente notamment les avantages suivants :
- Le fait d'inhiber un générateur de courant actif du dispositif CAPT et de geler sa configuration avant le début de l'émission d'un signal basse fréquence BF par l'antenne TX permet d'éviter de façon certaine à la valeur du niveau de référence REF de l'organe de détection du dispositif CAPT d'être changée pendant l'émission d'un signal basse fréquence BF. On évite ainsi les mauvaises/fausses détections. De plus, si le dispositif CAPT est capacitif, cela évite de façon sûre à ce dernier d'être brouillé ;
- Elle permet de ne pas confondre une coupure d'alimentation continue du dispositif CAPT avec une micro-coupure d'alimentation, et ce grâce au premier filtre temporel TF1, et par conséquent de ne pas suspendre l'auto-adaptation du niveau de référence REF lors d'une micro-coupure et donc de ne pas figer la valeur du niveau de référence REF lors d'une micro-coupure ;
- Elle permet de ne pas confondre une réalimentation du dispositif CAPT avec l'émission du signal basse fréquence BF, et ce grâce au deuxième filtre temporel TF2, et par conséquent de ne pas permettre l'auto-adaptation du niveau de référence REF lors de l'émission du signal basse fréquence BF ;
- Elle filtre les signaux parasites de la tension d'entrée Vin grâce au premier seuil de tension Vs1 ;
- une main d'un utilisateur qui entre dans le voisinage des jeux d'électrodes EA/EB avant l'émission BF et y demeure après ladite émission reste détectée à la fin de l'émission BF (car le dispositif de détection sauvegarde, avant l'émission BF, toute sa configuration, et notamment son niveau de référence mesurée avant l'émission BF) ; et
- une main d'un utilisateur qui entre dans le voisinage des jeux d'électrodes EA/EB pendant l'émission BF et y demeure au voisinage après ladite émission est détectée dès la fin de l'émission BF (car le dispositif de détection sauvegarde, avant l'émission BF et pendant toute l'émission BF, toute sa configuration, et notamment son niveau de référence mesurée avant l'émission BF).

### Deuxième mode de réalisation

Un deuxième mode de réalisation du dispositif de détection CAPT est illustré à la Fig. 7 et à la Fig. 8.

Selon ce deuxième mode de réalisation, outre les caractéristiques décrites précédemment, le dispositif de détection CAPT comporte en outre :
- une diode Zener Z pour protéger la tension du régulateur de tension REG et éviter ainsi les surtensions ;
- une première résistance R1 pour limiter le courant consommé dans la diode Zener Z en cas de surtension de la tension d'entrée Vin et dans le condensateur d'entrée C2 à la mise sou tension du dispositif de détection CAPT ; et
- Une première diode D1 en série avec le régulateur REG pour le protéger contre les inversions de tension batterie.

Selon ce deuxième mode de réalisation, le dispositif de détection CAPT comprend également :
- a) l'antenne TX et le dispositif de détection CAPT qui ont une alimentation commune ;
- b) l'élément de détection basse fréquence CMP de début d'émission d'un signal basse fréquence pour détecter un signal résonant représentatif d'une émission d'un signal basse fréquence BF ;
- c) le dispositif de détection CAPT est alimenté, pendant l'émission d'un signal basse fréquence BF, par une tension de résonance Vbf générée par l'antenne TX ; et
- d) les moyens d'inhibition INH inhibent un générateur de courant GA/GB dès que l'émission d'un signal basse fréquence BF est détecté.

Concernant le point la caractéristique b), on notera qu'un signal résonant comporte une amplitude en tension plus grande que la tension d'entrée Vin. Cela est donc plus facile à détecter.

Dans une première variante de réalisation non limitative, le signal résonnant est une tension de résonance Vbf, tel qu'illustré à la Fig. 7.
Dans cette variante, afin d'obtenir la tension de résonance, on accède directement à l'antenne TX. Ainsi, dans un exemple non limitatif, la tension de résonance Vbf est la tension aux bornes de l'inductance L de l'antenne TX. Dans un autre exemple, elle peut être la tension aux bornes de la capacité C de l'antenne TX.
Durant l'émission d'un signal basse fréquence BF, la tension d'entrée pulsée Vin induit une résonance sur l'antenne TX due au circuit résonant LC. Cela génère un signal résonant qui est une tension presque sinusoïdale nommée la tension de résonance Vbf, cette tension de résonance étant très supérieure au maximum de la tension d'alimentation Vin, ici de 12V.
En pratique, de façon résumée, afin de détecter le signal résonnant, l'élément de détection basse fréquence CMP permet de comparer la tension de résonance Vbf de l'antenne TX et une tension de référence Vref de sorte à détecter l'émission d'un signal basse fréquence BF. En comparant le résultat de la détection crête avec la valeur de référence Vref, on détermine que si le résultat est supérieur à cette valeur Vref, il existe un signal résonnant, et qu'il existe donc une émission basse fréquence BF.

Dans un exemple non limitatif, l'élément de détection basse fréquence CMP de début d'émission d'un signal BF comporte :
- une diode D3 associée avec un filtre RC,
- le filtre RC,
- un pont diviseur PT (qui est résistif dans un exemple non limitatif), et
- un transistor TR1 qui fournit une tension de référence Vref de 0,6V dans un exemple non limitatif.
La diode D3 permet de supprimer la composante négative dudit signal résonnant.
En association avec le filtre RC, elle permet également de faire une détection crête du signal redressé et d'obtenir un signal de sortie avec les valeurs crêtes détectées, ce signal étant une tension représentative du signal résonnant (tension image).
Le pont diviseur permet de diviser le signal de sortie de sorte à pouvoir le comparer avec la valeur de référence Vref.

Dans une deuxième variante de réalisation, le signal résonnant est un courant résonant Ibf. Cette deuxième variante est illustré à la Fig. 8.
Le courant résonant Ibf est le courant généré par la tension d'entrée Vin qui sert de tension d'excitation de l'antenne TX.
Dans cette variante, il n'est pas nécessaire d'avoir un accès direct à l'antenne comme c'était le cas dans la première variante décrite ci-dessus. Ainsi, cette variante est intéressante dans le cas où il n'existe aucun point d'accès à l'antenne TX.
Par ailleurs, le courant résonant Ibf est quasi-sinusoïdal et donc facile à traiter.

Durant l'émission d'un signal basse fréquence BF, la tension d'entrée pulsée Vin induit une résonance sur l'antenne TX due au circuit résonant LC. Cela génère un signal résonant qui est le courant.
En pratique, afin de détecter le signal résonnant, l'élément de détection basse fréquence CMP permet de comparer une tension image Vi image du signal résonant, qui est ici le courant résonant Ibf, avec une tension de référence Vref de sorte à détecter l'émission d'un signal basse fréquence BF. En comparant le résultat Vi de la détection crête avec la valeur de référence Vref, on détermine que si le résultat Vi est supérieur à cette valeur Vref, il existe un signal résonnant, et qu'il existe donc une émission basse fréquence BF.

A cet effet, dans un exemple non limitatif, l'élément de détection basse fréquence CMP de début d'émission d'un signal BF comporte :
- une résistance de mesure Rsp,
- une diode D3 associée avec un filtre RC,
- le filtre RC,
- un amplificateur AV, et
- un transistor TR1 qui fournit une tension de référence Vref de 0,6V dans un exemple non limitatif.
La résistance de mesure Rsp permet d'obtenir la tension image Vi, image du signal résonant Ibf. Dans un mode de réalisation non limitatif, la résistance de mesure Rsp est faible (de l'ordre de quelques Ohms) de sorte à ne pas modifier l'amplitude du courant Ibf. La diode D3 permet d'effectuer un redressement mono-alternance à partir de la tension image Vi.
En association avec le filtre RC, elle permet également de faire une détection crête du signal redressé et d'obtenir un signal de sortie avec les valeurs crêtes détectées.
L'amplificateur AV permet d'amplifier la valeur de la tension image Vi afin de pouvoir comparer cette tension image Vi avec la tension de référence Vref, En effet, dans le cas d'un résistance de mesure Rsp de faible valeur, la tension image Vi obtenue est de faible valeur (dans un exemple non limitatif inférieure à 1 V).

Pour les deux variantes de réalisation, pour de plus amples détails sur la détection crête, on se référera à la description sur le sujet dans le troisième mode de réalisation.

Dans une troisième variante de réalisation, on peut effectuer un couplage entre l'inductance de l'antenne TX et une inductance externe et récupérer la tension image du courant induit par effet transformateur.

Concernant le point la caractéristique c), la tension de résonance Vbf est utilisée pour maintenir l'alimentation du dispositif de détection CAPT, pendant l'émission d'un signal basse fréquence BF.
Dans un exemple non limitatif, cela est effectué par une simple diode D4 comme illustré sur la Fig. 7 et la Fig. 8.
Dans un mode de réalisation non limitatif, cette diode D4 est également associée à une résistance R4 formant un pont diviseur résistif avec la première résistance R1.
Pendant l'émission d'un signal basse fréquence BF, lors d'une alternance positive de la tension d'entrée pulsée Vin, le condensateur d'entrée C2 se charge. La tension Vin alimente le dispositif de détection CAPT.
Lors d'une alternance négative de la tension d'entrée pulsée Vin, la diode D4 est en inverse (elle est bloquée) et elle évite donc que le condensateur C2 ne se décharge vers l'antenne TX. Le condensateur d'entrée C2 permet ainsi toujours d'alimenter le dispositif de détection CAPT et en particulier le dispositif de sauvegarde LOGIC et les moyens d'inhibition INH.
Ainsi, lors de l'alternance positive, on recharge le condensateur d'entrée C2 grâce à la tension de résonance Vbf.
On notera que la diode D4 et la résistance R4 en association avec la résistance R1 sont déterminées de telle sorte que le chargement lors de l'alternance positive s'effectue plus rapidement que la décharge du condensateur d'entrée C2 lors des deux alternances positives et négatives de la tension d'entrée pulsée Vin.
Ainsi, on maintient l'alimentation du dispositif de détection CAPT.

Concernant le point la caractéristique d),
Dès que l'émission d'un signal basse fréquence BF est détecté par l'élément de détection basse fréquence CMP, les moyens d'inhibition INH inhibent un générateur de courant GA/GB.
Comme vu précédemment, dans des exemple non limitatifs :
- les moyens d'inhibition INH sont le circuit de commande LOGIC qui désactive la sortie en courant (état de la sortie à 0) du dispositif CAPT correspondant au générateur de courant qui est actif (ici le générateur GA) ;
- les moyens d'inhibition INH peuvent être un transistor TR2 qui vient tirer à la masse la commande du générateur de courant GA et ainsi couper l'alimentation du générateur de courant lui-même, celui qui est actif (ici le générateur GA). Dans un exemple non limitatif.
Comme vu précédemment pour le premier mode de réalisation, ces moyens d'inhibition permettent d'éviter au dispositif de détection CAPT, plus particulièrement au dispositif de sauvegarde LOGIC, de se réinitialiser, et donc de perdre la valeur du niveau de référence qui a été sauvegardée auparavant.

De plus, ces moyens d'inhibition INH évitent à l'émission BF d'être perturbée par toute consommation d'alimentation du dispositif de détection CAPT, ce dernier étant ici alimenté par la tension de résonance Vbf comme vue précédemment, et ce pour les raisons suivantes.
Si pendant l'émission d'un signal basse fréquence BF, la main d'un utilisateur coopère avec une poignée de telle sorte que l'organe de détection EA est activé, le dispositif de sauvegarde LOGIC de l'organe de détection EA le détecte car un courant Ipsu égale à I_{A} + I_{IDLE} est généré.

Le générateur de courant GA génère le courant I_{A} lorsque la tension d'entrée Vin est à 0V/+12V (alternance positive = 1^{ère} demie-phase du signal pulsé Vin), la première diode D1 étant passante.
Par contre, le générateur de courant GA ne génère aucun courant I_{A} lorsque la tension d'entrée Vin est à -12V/0V (alternance négative = 2^{ème} demie-phase du signal pulsé Vin), la première diode D1 étant bloquée.
Comme on l'a vu précédemment, le courant commun Ipsu se réparti en un courant capteur I_{CAPT} et en un courant d'antenne I_{TX}.
Ainsi, lorsque le dispositif de détection CAPT fonctionne sans émission BF, le courant commun Ipsu = I_{CAPT}.
Par contre, lorsque le dispositif de détection CAPT fonctionne avec une émission BF, le courant commun Ipsu = I_{CAPT} + I_{TX}. On rappelle que cela peut se faire car le dispositif de détection est alimenté par la tension de résonance Vbf.
Ainsi,
I_{CAPT} = 0 lors de l'alternance négative (première diode D1 bloquée), et
I_{CAPT} = I_{A}+I_{IDLE} ou I_{B}+ I_{IDLE} ou I_{A} + I_{B}+I_{IDLE} lors de l'alternance positive (première diode D1 passante).
Or ce courant commun Ipsu est consommé par l'antenne TX lors de l'émission d'un signal BF.
Comme le capteur consomme également une partie du courant commun (I_{CAPT}), lors d'une alternance positive de la tension d'entrée pulsée Vin, il y a donc moins de courant qui circule dans l'antenne TX ce qui va déformer le signal résonnant aux bornes de l'antenne TX. On aura ainsi, un signal déformé lors d'une alternance négative, et un signal normal lors d'une alternance positive, ce qui en définitive induira un signal de résonance déformé.

Or ce signal résonnant est utilisé pour créer un champ magnétique qui va permettre une communication avec un objet d'identifiant détenue par l'utilisateur. En conséquence, la communication sera mauvaise ou sera perdue et/ou on aura une perte de porté du champ magnétique issu du signal résonnant.
Ainsi, le fait d'inhiber les générateurs de courants EA/EB (soit le générateur EA qui est actif dans l'exemple pris), permet d'éviter au dispositif de détection de consommer du courant commun qui devrait être consommé par l'antenne TX. Ainsi, on ne déforme pas le signal résonnant, et l'émission d'un signal BF n'est pas brouillée.

On notera que dans ce deuxième mode de réalisation, la sauvegarde, pendant l'émission d'un signal basse fréquence BF, d'une valeur du niveau de référence REF mesurée avant l'émission dudit signal basse fréquence BF, s'effectue au moins jusqu'à la fin de l'émission du signal basse fréquence BF et au moins jusqu'à ce qu'il n'y ait plus de détection de signal résonnant Vbf.
En pratique, la fin de l'émission d'un signal BF signifie que :
- le condensateur du filtre RC s'est déchargé de sorte que
- le transistor TR1 qui fournit la tension de référence Vref soit bloqué.
Après l'émission du signal basse fréquence BF, on ré-autorise donc l'auto-adaptation du niveau de référence REF de la grandeur physique CE.
Après l'émission du signal basse fréquence BF, l'auto-adaptation s'exécutera de nouveau et une nouvelle valeur du niveau de référence REF sera sauvegardée lorsque :
- la main de l'utilisateur ne sera plus présente, ou
- lorsqu'un un délai TIMEOUT sera dépassé
comme vu précédemment dans le premier mode de réalisation.

Ainsi ce deuxième mode de réalisation présente notamment les avantages suivants :
- le dispositif de détection CAPT demeure correctement alimenté, même pendant l'émission d'un signal basse fréquence BF. Il peut donc continuer à détecter la présence d'un objet tel que la présence d'une main ;
- le dispositif de détection CAPT n'est pas perturbé par l'émission basse fréquence BF lorsqu'il est capacitif ;
- une main d'un utilisateur qui entre dans le voisinage des jeux d'électrodes EA/EB avant l'émission BF et y demeure après ladite émission reste détectée à la fin de l'émission BF (car le dispositif de détection sauvegarde, avant l'émission BF, toute sa configuration, et notamment son niveau de référence mesurée avant l'émission BF) ;
- une main d'un utilisateur qui entre dans le voisinage des jeux d'électrodes EA/EB pendant l'émission BF et y demeure au voisinage après ladite émission est détectée dès la fin de l'émission BF (car le dispositif de détection sauvegarde, avant l'émission BF et pendant toute l'émission BF, toute sa configuration, et notamment son niveau de référence mesurée avant l'émission BF) ; et
- une émission d'un signal basse fréquence BF ne sera plus perturbée par une consommation de courant par le dispositif de détection CAPT, grâce à l'inhibition des générateurs de courant (qui sont actifs).

### Troisième mode de réalisation

Un troisième mode de réalisation du dispositif de détection CAPT est illustré à la Fig. 9.
Selon ce troisième mode de réalisation, outre les caractéristiques décrites précédemment, le dispositif de détection CAPT comporte en outre :
- une diode Zener Z pour protéger la tension du régulateur de tension REG et éviter ainsi les surtensions ;
- une première résistance R1 pour limiter le courant consommé dans la diode Zener Z en cas de surtension de la tension d'entrée Vin et dans le condensateur d'entrée C2 à la mise sous tension du dispositif de détection CAPT ; et
- Une première diode D1 en série avec le régulateur REG pour le protéger contre les inversions de tension batterie.

Selon ce troisième mode de réalisation, le dispositif de détection CAPT comprend également :
- a) l'antenne TX et le dispositif de détection CAPT qui ont une alimentation commune ;
- b) l'élément de détection basse fréquence CMP de début d'émission d'un signal basse fréquence pour détecter un signal d'entrée pulsé représentatif d'une émission d'un signal basse fréquence BF ; et
- c) les moyens d'inhibition INH pour inhiber un générateur de courant GA/GB dès que l'émission d'un signal basse fréquence BF est détecté.

Concernant le point la caractéristique c), la description du deuxième mode de réalisation décrit ci-dessus s'applique.

Concernant le point la caractéristique b), dans une variante de réalisation non limitative, le signal d'entrée pulsé est la tension d'entrée Vin. Ainsi, pour détecter le début d'émission d'un signal basse fréquence BF, on cherche à déterminer le moment où la tension d'entrée Vin passe d'une tension continue de +12V dans l'exemple pris à une tension pulsée -12V/0V/+12V dans l'exemple pris. En effet, comme expliqué précédemment, durant l'émission d'un signal basse fréquence BF, la tension d'entrée Vin est pulsée.

En pratique, de façon résumée, afin de détecter directement le signal pulsé Vin, l'élément de détection basse fréquence CMP permet de comparer la tension d'entrée Vin qui alimente le capteur CAPT avec une tension de référence Vref2 de sorte à détecter l'émission d'un signal basse fréquence BF. Ainsi, on effectue une détection crête à crête du signal d'entrée Vin. En comparant le résultat de la détection crête avec une valeur de référence Vref2, on détermine que si le résultat est supérieur à cette valeur Vref2, le signal est pulsé et qu'il existe donc une émission basse fréquence BF.

Dans un mode de réalisation non limitatif, l'élément de détection basse fréquence CMP de début d'émission d'un signal BF comporte à cet effet, tel qu'illustré à la Fig. 10 :
- une deuxième diode D2,
- une troisième diode D3 associée avec un filtre R4C5,
- le filtre R4C5,
- une cinquième résistance R9, et
- un transistor TR1 qui fournit une tension de référence Vref2, dans un exemple non limitatif de 3V.

Ces éléments sont décrits en détail ci-après.
- La première diode D3 permet de supprimer la composante négative dudit signal Vin. On obtient le premier signal de sortie S1 illustré de façon schématique à la Fig. 11. Ce signal est également appelé signal d'entrée détecteur crête.
- la deuxième diode D2 en association avec le condensateur C5 permet de faire la détection crête du signal redressé et d'obtenir un signal de sortie S2 avec les valeurs crêtes détectées. Ces deux composants forment ainsi un détecteur crête.

En effet, lors des alternances positives du signal d'entrée pulsé Vin (signal de sortie S1 positif), le condensateur C5 du filtre R4C5 se charge via la diode D2, et la résistance R4. On notera qu'il faut plusieurs alternances positives pour charger le condensateur C5 en relation avec la constante de temps CT45.

Par ailleurs, on notera que la diode D2 empêche le condensateur C5 de se décharger.
On notera que par ailleurs, lorsque la tension de charge Vch5 du condensateur C5 est supérieure à la tension de seuil Vref2 de commutation du transistor TR1, on peut couper l'alimentation des générateurs de courant. Ainsi, comme décrit précédemment, cela évite d'utiliser l'énergie emmagasinée dans le premier condensateur C1 et donc on évite de réinitialiser la logique de commande LOGIC du capteur CAPT.
- La cinquième résistance R9 permet au condensateur C5 de se décharger lorsque la deuxième diode D2 est bloquée. Cette résistance est déterminée de sorte que la décharge du condensateur C5 soit plus lente que sa charge. Ainsi, dans un mode de réalisation non limitatif, il existe un facteur compris entre 10 et 20 entre la résistance R4 (permettant la charge dudit condensateur C5) et cette résistance R9, la résistance R9 étant plus grande que la résistance R4. Cela permet au condensateur C5 de se décharger complètement lorsqu'il n'existe plus d'émission de signal basse fréquence BF. Ainsi, cela permet de désactiver l'inhibition des générateurs de courants GA/GB de sorte à rendre de nouveau actif la détection, c'est-à-dire la fonction capteur.
Sans cette résistance R9, le condensateur C5 ne se déchargerait plus et on ne pourrait plus désactiver l'inhibition des générateurs de courant.

Ainsi, lors de l'émission d'un signal basse fréquence BF, en sortie du filtre R4C5 on obtient le deuxième signal de sortie S2 illustré de façon schématique à la Fig. 11 qui est une tension représentative de l'amplitude maximale du signal d'entrée pulsé Vin. Ainsi, ce signal de sortie S2 (qui correspond à la charge et décharge du condensateur C5) est donc représentatif de l'émission d'un signal basse fréquence BF.

La tension du condensateur C5 est dans un régime stabilisé pendant toute l'émission du signal basse fréquence BF. A partir de ce signal de sortie S2, après stabilisation, ici au temps t4 comme illustré sur la Fig. 11, en prenant les valeurs crêtes, on les compare par rapport à la tension de référence Vref2. Si elles sont supérieures à ladite valeur de référence Vref2, on déduit que le signal d'entrée Vin est pulsé et donc qu'il existe une émission de signal basse fréquence BF. On notera que ce signal de sortie S2 est également appelé tension de sortie U_{R9} par la suite (tel qu'illustré sur la Fig. 10).
- Le transistor TR1 permet de :
   - fournir la tension de référence Vref2 pour la détection crête, et
   - inhiber les générateurs de courant GA/GB qui sont actifs en les mettant à la masse.
On utilise ainsi un seul composant pour effectuer deux fonctions.
Dans le cas de la fonction d'inhibition, lorsque la tension de charge Vch5 devient supérieure à la tension seuil de commutation Vref2, alors le transistor TR1 conduit (il commute). A ce moment, le générateur de courant qui est actif, dans l'exemple GA, est bloqué (sa tension égale 0). Il n'existe plus de courant de sortie générateur I_{A}. Le générateur de courant GA est donc inhibé.
De cette manière, dès la détection du signal basse fréquence BF, le(s) générateur(s) de courant qui est actif(s) est inhibé(s).

Bien entendu, dans un autre mode de réalisation, on peut utiliser un autre transistor différent du transistor TR1 pour effectuer la fonction d'inhibition.
Dans un autre mode de réalisation également, on peut effectuer une inhibition logique comme décrit précédemment dans les premier et deuxième modes de réalisation.
- les composants D2 et C5 permettent d'effectuer la détection crête comme expliqué ci-dessus.

La constante de temps CT45 du filtre R4C5 est définie de sorte à permettre une détection crête rapide quand l'émission d'un signal basse fréquence BF a commencé, permettant un chargement rapide du condensateur C5 de sorte à obtenir une commutation positive (état ON) du transistor TR1 rapide, et ainsi une détection rapide de l'émission basse fréquence BF.
Par ailleurs, on notera que la tension d'entrée pulsée Vin peut comporter des pics de tension parasites dus par exemple à l'environnement du véhicule automobile, au bruit, au couplage électromagnétique, au faisceau électrique du véhicule etc.
En raison de ces pics, la tension de charge Vch5 du condensateur C5 peut augmenter de sorte à entraîner la commutation du transistor TR1 et l'inhibition du générateur de courant actif, ici GA, comme décrit précédemment.
Afin d'éviter de telles perturbations, dans un mode de réalisation non limitatif, la constante de temps CT45 du filtre R4C5 est également définie de sorte à éviter un chargement trop rapide du condensateur C5 et ainsi ne pas prendre en compte des pics de tension parasites de la tension d'entrée pulsée Vin.

On définit ainsi la constante de temps CT45 de manière à avoir une balance entre une charge rapide pour détecter rapidement l'émission du signal BF mais cependant pas trop rapide pour éviter les pics de tension parasites et donc éviter des commutations intempestives du transistor TR1. On notera que dans un exemple non limitatif, cette constante de temps CT45 est égale à une ou deux périodes T_{BF}.

On notera que si la valeur du condensateur C5 est trop faible, le condensateur C5 se charge et se décharge très rapidement. Cela entraîne du bruit sur la tension de sortie U_{R9} (la tension U_{R9} subit des variations).
De plus, le fait d'avoir une valeur du condensateur faible entraîne que la tension de sortie U_{R9} est plus faible.

Le fait d'avoir une tension faible et du bruit entraîne un risque d'avoir des commutations intempestives du transistor TR1 pendant l'émission d'un signal basse fréquence, la tension de sortie U_{R9} risquant de repasser en dessous du seuil de commutation dudit transistor TR1. Le condensateur C5 influe donc sur la détection de l'émission d'un signal basse fréquence.
De plus, si la valeur du condensateur C5 est faible, il existe très peu de filtrage entre la tension de sortie U_{R9} et la tension d'entrée S1 du détecteur crête. En conséquence, lors de la réalimentation du capteur, la commutation de la tension d'entrée Vin (pour qu'elle redevienne continue) pour réalimenter le capteur se répercute sur la tension d'entrée S1 du détecteur crête, qui elle-même se répercute sur la tension de sortie U_{R9}. On peut donc observer un pic de tension sur la tension de sortie U_{R9} lors de la commutation de la tension d'entrée Vin. Il y a donc un risque que la tension de sortie U_{R9}, repasse au dessus du seuil de commutation du transistor TR1, ce que l'on ne veut pas lors de la réalimentation du capteur. Le condensateur C5 influe donc également sur l'immunité de la fonction capteur.

Par ailleurs, On notera que si la valeur du condensateur C5 est trop grande (par rapport au condensateur C6 décrit plus loin), le temps de charge et décharge du condensateur C5 devient très lent. Les variations de la tension d'entrée S1 du détecteur crête sont filtrées et ne sont plus ou très peu répercutées sur la tension de sortie U_{R9}. Il y a donc très peu de bruit sur ladite tension de sortie U_{R9}. Cependant, plus la décharge du condensateur C5 est lente, plus le temps de retour tn2 à l'état bloqué du transistor TR1 augmente. Ce temps tn2 correspond à un temps de latence entre la fin de l'émission basse fréquence et le retour à la disponibilité de la fonction capteur. Plus ce temps de latence tn2 est grand, moins on rend disponible la fonction capteur après l'émission basse fréquence. En effet, pendant ce temps de latence tn2, on ne peut réalimenter le capteur car le transistor TR1 est toujours passant (état 0) et bloque ainsi l'alimentation capteur.
De plus, plus le temps de charge du condensateur C5 est lent, plus la détection de l'émission basse fréquence est lente.
En effet, plus la valeur du condensateur C5 est élevée, plus la comparaison entre la tension de sortie U_{R9} avec la tension seuil de commutation du transistor TR1 sera lente. En effet, plus la valeur du condensateur C5 est élevée, moins vite les variations de la tension d'entrée Vin (lors de l'émission basse fréquence) se répercuteront sur la tension de sortie U_{R9}.
En conséquence, la détection de l'émission basse fréquence sera plus lente (l'émission basse fréquence étant déterminée par une tension de sortie U_{R9} supérieure à la tension seuil de commutation du transistor TR1). Ainsi, le temps de latence tn1 existant pour déterminer l'émission basse fréquence sera plus élevé.

En conclusion, comme le condensateur C5 influe sur l'immunité de la fonction capteur et sur la détection de l'émission basse fréquence, il faut déterminer une valeur du condensateur C5 de manière à avoir un bon compromis entre le bruit sur la tension de sortie U_{R9}, un temps de retour tn2 à disponibilité de la fonction capteur minimum et un temps de détection tn1 d'émission basse fréquence minimum.
Dans un mode de réalisation non limitatif, le temps de retour tn2 se compte en millisecondes, tandis que le temps de détection tn1 se compte en microsecondes.
Dans un exemple non limitatif, le temps de retour tn2 est inférieur ou égal à 12ms. Au dessus de ce seuil, il y a un plus grand risque que lorsque l'utilisateur appuie sur la poignée, il ne se passe rien, ou qu'il y ait une non détection de la disparition d'un appui long.
Dans un autre exemple de réalisation, le temps de retour tn2 est égal à 2ms. Cela permet de réduire la consommation d'énergie.
Dans un exemple non limitatif, le temps de détection tn1 est égal à 128microsecondes. Cela permet de détecter le premier bit de l'émission BF.
- Le pont diviseur de tension défini par R9/R4 influe sur la valeur moyenne de la tension de sortie U_{R9} du détecteur crête D2C5 pendant l'émission d'un signal basse fréquence BF.
Plus la valeur R9/R4 est élevée, plus la tension de sortie U_{R9} du détecteur crête D2C5 est élevée, ce qui permet une bonne commutation du transistor TR1 (U_{R9} étant très supérieur au seuil de commutation Vref2 du transistor TR1) i.e. que les niveaux haut et bas du transistor sont bien discrétisés l'un par rapport à l'autre.
Pour avoir une valeur R9/R4 élevée, on peut diminuer la valeur de la résistance R4.
Cependant, si la valeur de la résistance R4 est trop faible, cela entraîne une constante de temps CT45 du filtre R4C5 faible et donc une charge et une décharge rapide du condensateur C5. En conséquence, il existe du bruit sur la tension U_{R9}. Ce bruit entraîne un possible recoupement avec la tension seuil de commutation du transistor TR1.

De la même manière, si on diminue trop la valeur de la résistance R9 et donc le ratio R9/R4, on peut avoir du bruit sur la tension de sortie U_{R9} et avoir une tension de sortie trop faible par rapport au seuil de commutation du transistor TR1.

Pour diminuer ce bruit, on peut augmenter la valeur de la résistance R4 et augmenter la valeur de la résistance R9.
Cependant, le rapport R9/R4 influe également sur l'immunité du circuit de détection DETECT lors de la réalimentation du dispositif de détection CAPT (la réalimentation permettant de rendre disponible la fonction capteur). En effet, plus on augmente le rapport R9/R4, plus le temps de retour tn2 à l'état bloqué du transistor TR1 augmente. Ce temps tn2 correspond à un temps de latence entre la fin de l'émission basse fréquence et le retour à la disponibilité de la fonction capteur. Plus ce temps de latence tn2 est grand, moins on rend disponible la fonction capteur après l'émission basse fréquence. En effet, pendant ce temps de latence tn2, on ne peut réalimenter le capteur car le transistor TR1 est toujours passant état 0) et bloque ainsi l'alimentation capteur.

En conclusion, le rapport R9/R4 influençant le temps de retour tn2 à la fonction capteur et le bruit de la tension de sortie U_{R9}, il faut régler ce rapport de manière à avoir un bon compromis entre un temps de retour convenable pour avoir accès de nouveau à la fonction capteur, et un bruit assez faible qui ne risque pas de refaire commuter le transistor TR1.

Dans un mode de réalisation non limitatif, l'élément de détection basse fréquence CMP de début d'émission d'un signal BF comporte en outre un quatrième condensateur C6, tel qu'illustré à la Fig. 10.
- En période transitoire, à la fin de l'émission basse fréquence, lorsque la tension d'entrée Vin redevient continue et réalimente le capteur CAPT en continue, elle repasse de 0V à 12V dans l'exemple pris.
Dans ce cas, la transition entre 0V et 12V entraîne la recharge du condensateur C5. Ce chargement peut entraîner l'inhibition du générateur de courant actif GA comme expliqué précédemment. Il faut donc éviter cette inhibition et donc éviter que la tension de charge Vch5 du condensateur C5 ne soit supérieure à la tension seuil de commutation Vref2 du transistor TR1 lors d'une telle transition.

De même que le ratio R9/R4, le ratio C6C5 est défini pour éviter ce problème et obtenir le résultat décrit ci-dessus.

Ce quatrième condensateur C6 influe sur la valeur moyenne de la tension d'entrée S1 du détecteur crête D2C5, et donc sur sa tension de sortie U_{R9}.
Plus la valeur du condensateur C6 est élevée, plus la valeur moyenne de la tension d'entrée S1 est grande, et plus la valeur de pic sur la tension de sortie U_{R9} est grande, et donc plus la commutation du transistor TR1 sera bonne (niveaux haut et bas du transistor bien discrétisés), comme expliqué précédemment.
De plus, la comparaison avec la tension seuil de commutation du transistor TR1 sera rapide. En effet, plus la valeur du condensateur C6 est élevée, plus vite les variations de la tension d'entrée Vin (lors de l'émission basse fréquence) se répercuteront sur la tension de sortie U_{R9}.
En conséquence, la détection de l'émission basse fréquence sera plus rapide (l'émission basse fréquence étant déterminée par une tension de sortie U_{R9} supérieure à la tension seuil de commutation du transistor TR1). Ainsi, le temps de latence tn1 existant pour déterminer l'émission basse fréquence sera plus faible.

Cependant, plus la valeur du condensateur C6 est élevée, plus le circuit de détection DETECT sera sensible lors de la réalimentation du capteur CAPT. En effet, la réalimentation du capteur CAPT s'effectue par la commutation de la tension d'entrée Vin (pour qu'elle redevienne continue). La commutation de la tension d'entrée Vin entraîne des pics de tension sur la tension de sortie U_{R9}.
Plus la valeur de pic sur la tension sortie U_{R9} est grande (en raison d'une valeur du condensateur élevée C6), plus cela peut entraîner des commutations intempestives du transistor TR1 qui risque donc de redevenir passant (état 0). Ces commutations intempestives bloqueraient donc la réalimentation du capteur.

En conclusion, le condensateur C6 influençant le temps de détection d'émission basse fréquence tn1 et l'immunité de la fonction capteur (risques de commutations intempestives du transistor TR1), il faut régler ce condensateur C6 de manière à avoir un bon compromis entre un temps de détection convenable et une réalimentation capteur fiable.

On remet ainsi en route la fonction de détection sans que le circuit de détection DETECT ne perturbe le capteur CAPT.
Ainsi, grâce à ce quatrième condensateur C6, on acquiert plus de robustesse par rapport au transitoire de la remise en fonction (état ON) du capteur CAPT.

On notera que l'on peut diminuer la valeur du condensateur C6 (et donc du ratio C6/C5) à condition d'augmenter la valeur de la résistance R9 (et donc de R9/R4). Cela permet d'augmenter l'immunité du circuit de détection DETECT lors de la réalimentation de la fonction capteur sans pour autant pénaliser ni la tension de sortie U_{R9} du détecteur crête D2C5, ni le temps de retour tn2 à la disponibilité de la fonction capteur.

Ainsi, on trouve un compromis entre les deux ratios R9/R4 et C6/C5.

Les deux tableaux ci-dessous récapitulent l'influence des composants R4, R9, C6 et C5 vus ci-dessus sur les temps de latence tn1, tn2, sur la tension de sortie U_{R9}, et sur l'immunité de la fonction capteur.

| | **R4** | | **R9** | |
|---|---|---|---|---|
| Valeur | faible | forte | faible | forte |
| **tn1** | baisse | augmente | pas de détection | pas d'influence |
| **U_{R9}** | augmente/ bruit augmente | diminue | | augmente |
| **tn2** | pas d'influence | pas d'influence | | augmente |
| **Immunité capteur** | diminue | augmente | | diminue |

| | **C6** | | **C5** | |
|---|---|---|---|---|
| Valeur | faible | forte | faible | forte |
| **tn1** | pas de détection | diminue | diminue | augmente |
| **U_{R9}** | | augmente | plus de bruit | baisse |
| **tn2** | | pas d'influence | baisse | augmente |
| **Immunité capteur** | | baisse | baisse | augmente |

On notera que dans un mode de réalisation non limitatif, les composants R9, R4, C5 et C6 sont dimensionnés pour fonctionner à la fréquence d'excitation de la tension Vin (Vin servant de tension d'excitation pour l'antenne TX), qui est dans l'exemple pris de 125kHz. Cela évite que ces composants ne détectent un bruit parasite, et cela permet de bien détecter le signal venant de l'excitation de l'antenne TX, c'est-à-dire l'émission d'un signal basse fréquence par l'antenne TX.

Les diagrammes de la Fig. 12 permettent d'expliquer plus en détail le fonctionnement du dispositif de détection CAPT selon ce troisième mode de réalisation.
- Au temps t0 de l'exemple de la Fig. 12, on se place dans le cas où il n'y a pas de main qui coopère avec une poignée P d'ouvrant du véhicule V. La description qui a été faite précédemment lors du premier mode de réalisation, s'applique ici également. Par soucis de concision, on ne la répétera pas. On se référera donc au temps t0 décrit précédemment dans le premier mode de réalisation.
- Au temps t1, l'utilisateur met sa main dans une poignée P d'ouvrant du véhicule V. La description qui a été faite précédemment lors du premier mode de réalisation, s'applique ici également. Par soucis de concision, on ne la répétera pas. On se référera donc au temps t1 décrit précédemment dans le premier mode de réalisation.
- Au temps t2, à la suite d'une détection da la présence d'une main d'un utilisateur qui coopère avec une poignée P, la tension d'entrée Vin devient un signal pulsé afin de permettre une alimentation de l'antenne TX pour qu'elle puisse émettre un signal basse fréquence BF. On s'est placé dans cet exemple dans le cas où la détection d'une main déclenche l'émission d'un signal basse fréquence BF. Bien entendu, le même principe peut s'appliquer en cas de « polling ».
La tension d'entrée Vin chute donc à zéro pendant un intervalle de temps t2-t3 équivalent au temps de déclenchement de l'émission d'un signal basse fréquence BF par l'antenne TX.
L'alimentation continue du dispositif CAPT est donc coupée.
Lorsque le dispositif CAPT n'est plus alimenté, il est désactivé et devient autonome, c'est-à-dire qu'il comporte encore suffisamment d'énergie pour faire une détection de présence.
Le condensateur d'entrée C2 commence à se décharger (sa tension Vc2 commence a diminuer progressivement) comme illustré sur le premier diagramme, ainsi que le condensateur C1 (sa tension Vc1 commence a diminuer progressivement) comme illustré sur le cinquième diagramme.
- Au temps t3, à la suite de la détection de présence d'une main, le signal basse fréquence BF est donc émis par l'antenne TX afin d'interroger l'objet d'identification ID détenu par l'utilisateur du véhicule et vérifier qu'il est bien associé audit véhicule V et permettre ainsi son accès. En retour, l'objet d'identification ID enverra une réponse radio-fréquence RF sur une fréquence typique (non limitative) de 433 MHz comprenant un code objet d'identification permettant son identification et des données de cryptage permettant son authentification pour permettre un accès véhicule par la suite. On notera que le renvoi de la réponse radio-fréquence RF, se fait avant que l'utilisateur ne tire sur la poignée P du véhicule V pour l'ouvrir.
Le signal basse fréquence BF est émis pendant un intervalle de temps t3-t5 avec une période T_{BF} définie de quelques micro-secondes en général correspondant typiquement à 125kHz. Bien entendu, d'autres fréquences peuvent être utilisées.
L'antenne TX fonctionnant sur une tension non continue pulsée, de -12V/0V/+12V dans l'exemple pris, comme on peut le voir sur le premier diagramme de la Fig. 5, à ce moment, la tension d'entrée Vin devient une telle tension pulsée.
- au temps t4, le comparateur CMP détecte l'émission du signal basse fréquence BF par la détection crête décrite précédemment à partir du signal d'entrée pulsé Vin. La sortie S_CMP du comparateur CMP est mis à 1 (état ON) telle qu'illustrée sur le deuxième diagramme de la Fig. 12.
On notera qu'il existe un temps de latence tn1 (entre t3 et t4) pour la détection qui est déterminé par la constante de temps CT45 comme expliqué précédemment.

Lorsque l'émission d'un signal basse fréquence BF est ainsi détectée, on suspend l'auto-adaptation du niveau de référence REF du dispositif CAPT, tel qu'illustré sur le troisième diagramme nommé FRZ_REF de la Fig. 12 (état ON).
La valeur du niveau de référence REF de la capacité du jeu d'électrodes EA est figée. C'est-à-dire que la dernière valeur du niveau de référence REF qui est sauvegardée en mémoire est la valeur du niveau de référence mesurée avant l'émission d'un signal basse fréquence BF.
La configuration du dispositif CAPT est ainsi gelée.

On notera que dans le cas où le dispositif CAPT est un dispositif capacitif, même si le dispositif CAPT reste suffisamment alimenté (C1 et C2 suffisamment chargées) lorsqu'il n'a plus d'alimentation continue de la part de la tension d'entrée générale Vin, c'est-à-dire qu'il est autonome (le dispositif CAPT peut encore détecter la présence d'une main qui coopère avec une poignée P), une telle émission BF brouille ledit dispositif en raison d'un couplage capacitif et/ou inductif parasite entre l'antenne TX et ledit dispositif de détection capacitif CAPT. L'antenne TX étant à proximité du dispositif détection CAPT (en général les deux éléments étant dans la poignée), il existe en effet un tel couplage capacitif et/ou inductif parasite. Ceci peut entraîner une variation importante du niveau de référence REF lorsque le dispositif CAPT est autonome et également des mauvaises/fausses détections de présence d'une main de l'utilisateur coopérant avec une poignée P de véhicule V.
On rappelle qu'une mauvaise détection est le fait de ne pas détecter la présence d'une main alors qu'il existe une telle main qui coopère avec une poignée P, tandis qu'une fausse détection est le fait de détecter la présence d'une main qui coopère avec une poignée, alors que ce n'est pas le cas.

Le fait de figer la valeur du niveau de référence REF du dispositif CAPT pendant l'émission d'un signal basse fréquence BF permet donc d'éviter ses variations de référence et des mauvaises/fausses détections. Cela permet donc de s'immuniser contre les perturbations engendrées par l'émission d'un signal basse fréquence BF pour le dispositif de détection capacitif.

On notera que comme le dispositif CAPT n'est plus alimenté en tension, il faut éviter qu'il ne tire du courant sinon les condensateurs C1 et C2 vont se décharger. On veut en effet qu'il demeure autonome afin de pouvoir sauvegarder sa valeur du niveau de référence REF. On inhibe donc le générateur de courant qui est actif, le générateur GA dans l'exemple pris, de sorte que ce dernier ne puisse plus générer de courant de sortie générateur I_{A}. Une telle inhibition est illustré à la Fig. 12 sur le quatrième diagramme INH_GA (état ON). Cette opération d'inhibition est effectuée, lorsqu'une détection d'émission basse fréquence est constatée, comme dans le cas où l'on a figé la valeur du niveau de référence REF.

Par ailleurs, comme le dispositif CAPT n'est plus alimenté en tension, il faut éviter qu'il ne tire du courant par les générateurs de courant GA, GB, car sinon, l'émission basse fréquence est perturbée. En effet, si le dispositif de détection CAPT tire du courant, cela augmente le courant capteur Icapt. Cela entraîne une diminution du courant d'antenne Iₜₓ (on rappelle que le courant commun Ipsu = Icapt + Iₜₓ). Le fait de diminuer le courant d'antenne Iₜₓ perturbe l'antenne et donc cela peut entraîner un défaut de communication BF et/ou affaiblir la portée antenne. Il y a donc un risque de non reconnaissance du code identification d'un objet portatif associé au véhicule et permettant notamment le verrouillage/déverrouillage du véhicule V. LE fait d'inhiber les générateurs de courant permet d'éviter ce problème de perturbation d'antenne TX.

Afin d'inhiber un générateur de courant, les deux variantes de réalisation (logique ou par un transistor) décrites précédemment dans les deux autres modes de réalisation peuvent être utilisées.
Ainsi, du fait de l'inhibition du générateur de courant GA, le courant commun Ipsu est égal au courant de veille I_{IDLE} uniquement, comme on peut le voir sur le septième diagramme de la Fig. 12 au temps t4. Le générateur de courant GA n'est donc plus actif.

Une telle inhibition évite que les condensateurs C1 et C2 ne se déchargent trop quand il n'existe plus de tension d'entrée Vin continue.
On peut voir qu'au temps t4, le premier condensateur C1 ne se décharge pas tel qu'illustré sur le cinquième diagramme de la Fig. 12. En effet, le condensateur C2 ne se décharge pas suffisamment pour qu'il puisse se décharger lui-même (le condensateur C2 peut se décharger tout de même encore un peu, mais ceci est dû au fait que le dispositif de sauvegarde LOGIC et le régulateur REG consomment un peu d'énergie pour leurs besoins propres, et non pas le générateur de courant GA comme illustré sur le premier diagramme de la Fig. 12), voire le condensateur C2 peut se recharger légèrement par la tension d'excitation d'antenne Vin.
Si le condensateur C2 se décharge, il ne se décharge pas suffisamment pour que le dispositif de détection CAPT se réinitialise et perde sa valeur de niveau de référence REF sauvegardée auparavant.
- Au temps t5, l'antenne TX ayant terminé d'émettre le signal basse fréquence BF, on peut de nouveau réalimenter le dispositif CAPT avec la tension d'entrée Vin.

Cette dernière redevient continue, après une période transitoire t5-t7, et est égale à 12V dans l'exemple pris, comme on peut le voir sur le premier diagramme de la Fig. 12. Il n'y a donc plus de coupure d'alimentation Vin pour le capteur CAPT.
La sortie S_CMP du comparateur CMP, illustrée sur le deuxième diagramme de la Fig. 12, est de nouveau égale à 0 (état OFF) au temps t6 après un temps de latence tn2 lié à un temps de décharge du condensateur C5 en association avec la résistance R9.
Le dispositif CAPT étant réalimenté, ses condensateurs C1 et C2 se rechargent jusqu'à la tension de régulation MAX et d'entrée Vin respectivement, comme on peut le voir respectivement sur le cinquième et premier diagrammes de la Fig. 12.
Lorsqu'il n'existe plus d'émission basse fréquence du dispositif de détection CAPT, après une période transitoire, on peut :
- libérer la sauvegarde de la valeur du niveau de référence qui a été mesurée avant l'émission BF, c'est-à-dire permettre de nouveau l'auto-adaptation (qui se fera en l'absence de main), et
- réactiver le(s) générateur(s) de courant GA/GB qui a été (ont) inhibé(s), ici le générateur GA.
- Au temps t6, on ré-autorise donc au dispositif de détection CAPT d'auto-adapter de nouveau le niveau de référence REF correspondant au jeu d'électrodes EA (qui se fera en l'absence de main), comme illustré sur le troisième diagramme FRZ_REF de la Fig. 12 (état OFF).
On notera que la valeur du niveau de référence REF qui a été mesurée avant l'émission du signal basse fréquence BF est toujours la valeur qui est sauvegardée, car la main est toujours détectée au temps t6 (sixième diagramme DETECT_EA de la Fig. 12). L'auto-adaptation ne se fera en réalité que lorsque la main sera de nouveau absente.

Au temps t6 également, le courant commun Ipsu est donc de nouveau égal au courant de veille I_{IDLE} et au courant I_{A} circulant dans le générateur de courant actif GA tel qu'illustré sur le septième diagramme de la Fig. 12.

La mesure du courant commun Ipsu par le contrôleur du véhicule ECU qui sert à voir si le dispositif CAPT est actif ou non, permet de voir qu'il est toujours actif, c'est-à-dire qu'il existe toujours la présence d'une main qui coopère avec la poignée P quand le dispositif CAPT est alimenté par la tension d'entrée Vin.
Ainsi, même si l'utilisateur du véhicule V à laissé longtemps sa main dans (avec ou sans contact) ou sur la poignée P (donc avec contact), c'est-à-dire au-delà de l'émission du signal basse fréquence BF, cette présence de main est toujours détectée par le dispositif CAPT. On évite ainsi de perdre l'information présence de main coopérant avec la poignée P après l'émission du signal basse fréquence BF. Le fait de détecter une coopération main-poignée qui dure après l'émission d'un signal basse fréquence BF (que l'on nomme souvent appui long) permet ainsi d'activer des fonctions de confort telles que, dans des exemples non limitatifs :
- remonter les vitres du véhicule jusqu'à ce que la main ne coopère plus avec la poignée P ;
- remonter la capote d'une voiture décapotable ;
- activer l'alarme du véhicule ; et
- super-condamner le véhicule, c'est-à-dire débrayer les poignées intérieures après un verrouillage des portes du véhicule (cela empêche un voleur d'ouvrir le véhicule de l'intérieur à l'aide des poignées après qu'il a cassé une vitre par exemple) etc.
Dans un exemple non limitatif, cet « appui long » peut durer jusqu'à 30 secondes.
- Au temps t8, le premier condensateur C1 et le deuxième condensateur C2 sont rechargés jusqu'à sa tension de régulation MAX et d'entrée Vin respectivement comme illustré sur le cinquième et premier diagrammes respectivement.
- Au temps t9, l'utilisateur du véhicule V sort sa main de la poignée P du véhicule V comme illustré sur le sixième diagramme DETECT_EA de la Fig. 12 (état OFF). Le générateur de courant GA n'est plus actif (état OFF), il n'y a plus de courant I_{A} qui circule. Le courant commun Ipsu devient égal au courant de veille I_{IDLE} uniquement.
La mesure du courant commun Ipsu par le contrôleur du véhicule ECU permet de voir que le dispositif de détection CAPT n'est plus actif, c'est-à-dire qu'il n'y a pas de présence de main qui coopère avec la poignée P considérée.

On notera que dans ce troisième mode de réalisation, la sauvegarde, pendant l'émission d'un signal basse fréquence BF, d'une valeur du niveau de référence REF mesurée avant l'émission dudit signal basse fréquence BF, s'effectue au moins jusqu'à la fin de l'émission du signal basse fréquence BF et au moins jusqu'à ce qu'il n'y ait plus de détection de signal pulsé Vin.
En pratique, la fin de l'émission d'un signal BF signifie que :
- le condensateur du filtre R9C5 s'est déchargé de sorte que
- le transistor TR1 qui fournit la tension de référence Vref2 soit bloqué.
Après l'émission du signal basse fréquence BF, on ré-autorise donc l'auto-adaptation du niveau de référence REF de la grandeur physique CE.
Après l'émission du signal basse fréquence BF, l'auto-adaptation s'exécutera de nouveau et une nouvelle valeur du niveau de référence REF sera sauvegardée lorsque :
- la main de l'utilisateur ne sera plus présente, ou
- lorsqu'un un délai TIMEOUT sera dépassé
comme vu précédemment dans le premier et deuxième modes de réalisation.

Ainsi, ce troisième mode de réalisation présente notamment les avantages suivants.
- Il permet de minimiser le temps de détection de l'émission d'un signal basse fréquence BF en contrôlant le temps de charge du condensateur C5 grâce à la constante de temps CT45 ;
- Il permet de remettre en route la fonction de détection par le capteur CAPT en un temps minimum après la fin d'émission d'un signal basse fréquence BF grâce à la résistance R9, au condensateur C5 et au quatrième condensateur C6 ;
- Il permet d'éviter les perturbations parasites transitoires lors du chargement du condensateur C5 grâce à la constante de temps CT45 ;
- une main d'un utilisateur qui entre dans le voisinage des jeux d'électrodes EA/EB avant l'émission BF et y demeure après ladite émission reste détectée à la fin de l'émission BF (car le dispositif de détection sauvegarde, avant l'émission BF, toute sa configuration, et notamment son niveau de référence mesurée avant l'émission BF) ;
- une main d'un utilisateur qui entre dans le voisinage des jeux d'électrodes EA/EB pendant l'émission BF et y demeure au voisinage après ladite émission est détectée dès la fin de l'émission BF (car le dispositif de détection sauvegarde, avant l'émission BF et pendant toute l'émission BF, toute sa configuration, et notamment son niveau de référence mesurée avant l'émission BF) ; et
- une émission d'un signal basse fréquence BF ne sera plus perturbée par une consommation de courant par le dispositif de détection CAPT, grâce à l'inhibition des générateurs de courant (qui sont actifs).

### Autres modes de réalisation

Bien entendu, les trois modes de réalisation exposés ci-dessus ne sont pas limitatifs. On peut imaginer avoir d'autres modes de réalisation dans lesquels :
- le niveau de référence REF est figé dès la détection d'une coupure d'alimentation continue du dispositif de détection CAPT comme dans le premier mode de réalisation, mais la ré-autorisation de l'auto-adaptation est permise à la fin de l'émission du signal basse fréquence comme dans le deuxième ou troisième mode de réalisation. On peut appliquer ce même principe pour l'inhibition/désinhibition d'un générateur de courant ;
- le niveau de référence REF est figé dès la détection d'un début d'émission d'un signal basse fréquence comme dans le deuxième ou troisième mode de réalisation, mais la ré-autorisation de l'auto-adaptation est permise à la fin de la coupure d'alimentation continue du dispositif de détection CAPT comme dans le premier mode de réalisation. On peut appliquer ce même principe pour l'inhibition/désinhibition d'un générateur de courant ;
- le premier mode de réalisation comporte également un dispositif de détection CAPT qui est alimenté par une tension de résonance Vbf générée par l'antenne TX pendant l'émission d'un signal basse fréquence, comme indiqué précédemment ;
- le troisième mode de réalisation comporte également un dispositif de détection CAPT qui est alimenté par une tension de résonance Vbf générée par l'antenne TX pendant l'émission d'un signal basse fréquence, comme indiqué précédemment ;
- etc.

Le dispositif de détection de présence CAPT selon l'invention permet ainsi de mettre en oeuvre le procédé de détection de présence d'un objet O au moyen d'une grandeur physique CE, associée à un organe de détection EA/EB, et qui varie en fonction de l'environnement où est placé ledit organe de détection EA/EB, comportant les étapes de :
- délivrer un niveau de référence REF variable de la grandeur physique CE et correspondant à l'absence d'un objet O ; et
- sauvegarder, pendant l'émission d'un signal basse fréquence BF, une valeur du niveau de référence REF mesurée avant l'émission dudit signal basse fréquence BF.

Par ailleurs, dans un mode de réalisation non limitatif, le procédé comporte en outre les étapes supplémentaires de :
- mesurer la grandeur physique associée à l'organe de détection ; et
- comparer la grandeur physique à la valeur du niveau de référence sauvegardée.

De plus, dans un mode de réalisation non limitatif, le procédé comporte en outre l'étape supplémentaire de suspendre la variation du niveau de référence.

De plus, dans un mode de réalisation non limitatif, le procédé comporte en outre l'étape supplémentaire de libérer ladite sauvegarde après l'émission du signal basse fréquence.

Enfin, dans un mode de réalisation non limitatif, la suspension de la variation du niveau de référence est effectuée dès que la présence d'un objet est détecté, ou dès qu'un signal basse fréquence est émis.

On notera que la mise en oeuvre du procédé de détection exposé ci-dessus peut être effectuée au moyen d'un dispositif micro programmé « software », d'une logique câblée et/ou de composants électroniques « hardware ».
Ainsi, le dispositif CAPT peut comporter un produit programme d'ordinateur PG comportant une ou plusieurs séquences d'instructions exécutables par une unité de traitement d'information telle qu'un microprocesseur, ou d'une unité de traitement d'un microcontrôleur, d'un ASIC, d'un ordinateur etc., l'exécution desdites séquences d'instructions permettant une mise en oeuvre du procédé décrit.
Un tel programme d'ordinateur PG peut être inscrit en mémoire non volatile inscriptible de type ROM ou en mémoire non volatile réinscriptible de type EEPROM ou FLASH. Ledit programme d'ordinateur PG peut être inscrit en mémoire en usine ou encore chargé en mémoire ou téléchargé à distance en mémoire. Les séquences d'instructions peuvent être des séquences d'instructions machine, ou encore des séquences d'un langage de commande interprétées par l'unité de traitement au moment de leur exécution.
Dans un exemple non limitatif, le programme d'ordinateur PG est inscrit dans une mémoire de l'unité de contrôle UC du dispositif CAPT.

Bien entendu, la description du dispositif de détection, de l'unité de détection et du procédé n'est pas limitée aux modes de réalisation et exemples décrits ci-dessus.

Ainsi, on peut avoir
- un dispositif de détection capacitif CAPT couplé à une antenne TX d'émission basse fréquence avec une alimentation commune ;
- un dispositif de détection non capacitif CAPT (dans un exemple non limitatif un dispositif de détection optique) couplé à une antenne TX d'émission basse fréquence avec une alimentation commune ;
- un dispositif de détection capacitif CAPT couplé à une antenne TX d'émission basse fréquence avec deux alimentations différentes.

Le premier et deuxième cas ont été illustrés ci-dessus. On notera qu'en ce qui concerne le troisième cas, l'invention fonctionne tout aussi bien, car dans ce cas, l'alimentation continue du dispositif CAPT est également coupée, non pas pour permettre l'alimentation de l'antenne TX comme dans les deux premiers cas, mais pour éviter un couplage capacitif et/ou inductif entre le dispositif et l'émission d'un signal basse fréquence BF et par suite empêcher audit dispositif d'être brouillé. De ce fait, bien que son alimentation ait été coupée, grâce à la fixation du niveau de référence à la valeur mesurée avant l'émission d'un signal basse fréquence, et à l'inhibition du (des) générateur(s) de courant actif(s), on peut toujours détecter une présence de main qui coopère avec une poignée P, même après l'émission d'un signal basse fréquence BF.

Ainsi, outre le mode de réalisation décrit des moyens de mesure du capteur CAPT concernant les générateurs de courants GA/GB, les moyens de mesure comprennent dans d'autres modes de réalisation :
- un unique générateur de courant GAB; ou
- deux interrupteurs à la masse TA/TB ; ou
- un unique interrupteur à la masse TAB.

Ainsi, dans un deuxième mode de réalisation des moyens de mesure tel qu'illustré à la Fig. 13, le capteur CAPT peut comporter un unique générateur de courant GAB comme moyens de mesure, associé aux deux organes de détection EA/EB, qui permet de générer un unique courant de sortie générateur I_{AB}, ce dernier étant codé en temporel par le circuit de commande LOGIC de manière à définir que le courant de sortie générateur I_{AB} correspond au premier organe de détection EA (jeu d'électrode(s)) ou au deuxième organe de détection EB (jeu d'électrode(s)). Le contrôleur ECU du véhicule décode par la suite le courant obtenu, en mesurant la largeur des impulsions de codage, ce qui permet de savoir quel est l'organe de détection EA/EB qui est activé. On détermine ainsi si la main est dans la poignée ou est sur la poignée comme expliqué précédemment et on déduit donc si la fonction verrouillage et/ou déverrouillage doit être activée.
On notera que ce deuxième mode de réalisation permet d'avoir une seule sortie et donc de réduire le nombre de fils et par conséquent de réduire la taille du capteur CAPT. On a donc une intégration du capteur CAPT dans une poignée de véhicule plus facile.
Par ailleurs le codage en courant permet d'avoir une meilleure immunité aux parasites électromagnétiques.
Dans une variante de réalisation, on peut prévoir un unique générateur de courant GAB délivrant deux courants différents I_{A} et I_{B}.

Dans un troisième mode de réalisation des moyens de mesure tel qu'illustré à la Fig. 14, le capteur CAPT peut comporter interrupteurs à la masse TA/TB comme moyens de mesure, associés respectivement à chaque organe de détection EA/EB, qui permettent de générer respectivement chacun une tension de sortie générateur U_{A}, U_{B}.
Dans un mode de réalisation non limitatif, les interrupteurs connectés à la masse TA/TB sont des transistors à collecteur ouvert. Le contrôleur ECU du véhicule comprend dans ce cas :
- une résistance R associée à chaque interrupteur TA/TB ; et
- une interface d'entrée INTF associée à chaque interrupteur TA/TB connectée à un microcontrôleur MICRO du contrôleur ECU. Dans un exemple de réalisation non limitatif, cette interface d'entrée est un inverseur INV.
Lorsqu'un organe de détection EA/EB est activé, l'interrupteur TA/TB associé délivre une tension de sortie générateur U_{A}/U_{B}. Le contrôleur ECU du véhicule permet de mesurer cette tension de sortie générateur U_{A}/U_{B} au moyen de la résistance R et de l'interface d'entrée associée INTF, et permet de déterminer selon sa valeur si :
- 1) une main se trouve dans la poignée P, que ce soit avec ou sans contact (tension INA = 5V aux bornes du microcontrôleur MICRO, correspondant à U_{A} = 0V lorsque l'interface d'entrée est un inverseur INV) ;
- 2) une main se trouve sur la poignée P (tension INB = 5V aux bornes du microcontrôleur MICRO, correspondant à U_{B} = 0V lorsque l'interface d'entrée est un inverseur INV) ;
- 3) une main se trouve dans la poignée P et est sur la poignée également (tension INA = INB = 5V aux bornes du microcontrôleur MICRO, correspondant à U_{A} = U_{B} = 0V lorsque l'interface d'entrée est un inverseur INV) ;
- 4) l'absence de main (tension INA = INB = 0V aux bornes du microcontrôleur MICRO, correspondant à U_{A} = U_{B} = Vbat lorsque l'interface d'entrée est un inverseur INV).
En fonction de la mesure de la tension, le contrôleur ECU permet alors d'effectuer une commande sur la serrure du véhicule correspondant à la détection effectuée (déverrouillage et/ou verrouillage de la serrure ou aucune commande) comme décrit précédemment dans le cas des moyens de mesure générateurs de courant GA/GB ; GAB.
On notera que :
- lorsqu'un organe de détection EA/EB est activé (une main est présente), l'interrupteur TA/TB correspondant conduit. A ce moment la tension générée est égale à U_{A} = U_{B} = 0V, soit la tension correspondante INA/INB à l'entrée du microcontrôleur MICRO est égale à 0V ou dans le cas d'une interface d'entrée inverseur à 5V.
- lorsqu'un organe de détection EA/EB n'est pas activé (une main est absente), l'interrupteur TA/TB correspondant est bloqué. A ce moment la tension générée est égale à U_{A} = U_{B} = Vbat, soit la tension correspondante INA/INB à l'entrée du microcontrôleur MICRO est égale à 5V ou dans le cas d'une interface d'entrée inverseur à 0V.

Dans un quatrième mode de réalisation de moyen de mesure tel qu'illustré à la Fig. 15, le capteur CAPT peut comporter un unique interrupteur à la masse TAB comme moyens de mesure, associé aux deux organes de détection EA/EB, qui permet de générer une unique tension de sortie générateur U_{AB}, cette dernière étant codée en temporel par le circuit de commande LOGIC de manière à définir que le tension de sortie générateur U_{AB} correspond au premier organe de détection EA (jeu d'électrode(s)) ou au deuxième organe de détection EB (jeu d'électrode(s)). Le contrôleur ECU du véhicule mesure la tension obtenue U_{AB} au moyen d'une résistance R et d'une interface INTF associée (qui peut être un inverseur INV) comme expliqué précédemment, et décode cette tension U_{AB} en mesurant la largeur des impulsions, ce qui permet de savoir quel est l'organe de détection EA/EB qui est activé (au moyen d'une tension INAB aux bornes du microcontrôleur MICRO, correspondant à U_{AB}). On détermine ainsi si la main est dans la poignée ou est sur la poignée comme expliqué précédemment et on déduit donc si la fonction verrouillage et/ou déverrouillage doit être activée.
On notera que ce quatrième mode de réalisation permet d'avoir une seule sortie et donc de réduire le nombre de fils et par conséquent de réduire la taille du capteur CAPT. On a donc une intégration du capteur CAPT dans une poignée de véhicule plus facile.

On notera que le troisième et quatrième mode de réalisation permettent d'avoir un capteur CAPT qui se base sur une mesure de tension, ce qui est plus simple à réaliser qu'une mesure en courant.

On notera le deuxième mode de réalisation permet de réduire le nombre de fils par rapport au troisième et quatrième mode de réalisation, ces derniers nécessitant respectivement deux et un fils supplémentaires par rapport au deuxième mode de réalisation.
On notera que la tension de 5V aux bornes du microcontrôleur MICRO a été prise comme exemple non limitatif.

Bien entendu, pour ces modes de réalisation également, selon la durée avec laquelle la main coopère avec une poignée P, le contrôleur ECU va pouvoir exécuter au moins une fonction de confort comme décrit précédemment.

Ainsi, l'invention présente notamment les avantages suivants :
- Elle permet non seulement de détecter l'intention de l'utilisateur du véhicule de verrouiller/déverrouiller le véhicule en détectant s'il met sa main respectivement sur une poignée/dans une poignée sans contact d'ouvrant du véhicule mais également de détecter l'intention de l'utilisateur de faire fonctionner une fonction de confort en détectant une coopération longue avec une poignée P d'ouvrant (un appui long sur une poignée P ou un positionnement long dans la poignée avec ou sans contact) ;
- Elle évite :
   - les pertes d'énergie des condensateurs C1 et C2 qui entraînerait une réinitialisation du dispositif de sauvegarde LOGIC, et ce grâce à l'inhibition du générateur de courant actif ; et
   - par la suite une réinitialisation de la valeur du niveau de référence REF de l'organe de détection EA/EB du dispositif CAPT ; et
   - par la suite une non détection d'une présence d'une main coopérant avec une poignée P ; et
   - donc également la non détection de la présence d'une main coopérant avec une poignée P après une émission d'un signal basse fréquence ;
- Le dispositif CAPT et l'antenne TX étant proches l'un de l'autre, elle permet d'éviter à un dispositif CAPT qui est capacitif d'être brouillé par l'antenne TX, et ce grâce à la sauvegarde, pendant l'émission d'un signal BF, de la valeur du niveau de référence REF mesurée avant l'émission d'un signal BF. En conséquence, si l'utilisateur du véhicule V laisse sa main dans la poignée P longtemps et/ou touche la poignée P longtemps, c'est-à-dire même après l'émission BF, cela est détecté ; et
- Elle évite au dispositif de sauvegarde LOGIC d'être réinitialisé, et ce grâce à l'inhibition du générateur de courant actif, et donc de perdre l'information qu'un jeu d'électrode(s) EA/EB est activé. On évite ainsi les mauvaises/fausses détections.

Bien entendu, l'invention décrite ci-dessus n'est pas limitée à l'application véhicule décrite ci-dessus. L'invention peut également s'appliquer dans toute application nécessitant la détection de présence d'un objet au voisinage d'un organe de détection avec émission d'un signal basse fréquence. Ainsi, on peut imaginer des applications telles que dans le domaine de l'électroménager ou des robinets (détection du passage de la main sous un robinet pour déclencher un jet d'eau) etc.

## Revendications

1. Dispositif de détection (CAPT) de présence d'un objet (O), le dispositif comprenant au moins un organe de détection (EA, EB) auquel est associée une grandeur physique (CE) qui varie en fonction de l'environnement où est placé ledit organe de détection (EA, EB),
la grandeur physique (CE) délivre un niveau de référence (REF) variable et correspondant à l'absence d'un objet (O)
ledit dispositif de détection comprenant en outre :
- un dispositif de sauvegarde (LOGIC) pour :
- sauvegarder, pendant l'émission d'un signal basse fréquence (BF), une valeur du niveau de référence (REF) mesurée avant l'émission dudit signal basse fréquence (BF) ;
- mesurer la grandeur physique (CE) associée à l'organe de détection (EA/EB) ;
- comparer la grandeur physique (CE) à la valeur du niveau de référence (REF) sauvegardée ;
**caractérisé en ce que** ledit dispositif de sauvegarde (LOGIC) est configuré de sorte à :
- suspendre la variation du niveau de référence (REF) dès que la présence d'un objet est détecté ou dès qu'un signal basse fréquence est émis ;
- libérer ladite sauvegarde après l'émission du signal basse fréquence (BF).

2. Dispositif de détection (CAPT) selon l'une des revendications précédentes, selon lequel la grandeur physique (CE) est une capacité.

3. Dispositif de détection (CAPT) selon l'une des revendications précédentes, selon lequel la grandeur physique (CE) est un flux lumineux.

4. Dispositif de détection (CAPT) selon l'une des revendications précédentes, selon lequel il comporte en outre :
- un élément de détection basse fréquence (CMP) de début d'émission d'un signal basse fréquence (BF).

5. Dispositif de détection (CAPT) de présence selon l'une des revendications précédentes, selon lequel il est alimenté par une alimentation commune (Vin) à une antenne (TX) d'émission d'un signal basse fréquence (BF).

6. Dispositif de détection (CAPT) selon l'une des revendications précédentes, selon lequel il est alimenté, pendant l'émission d'un signal basse fréquence (BF), par une tension d'excitation d'antenne (TX), ladite antenne permettant d'émettre le signal basse fréquence (BF).

7. Dispositif de détection (CAPT) de présence selon l'une des revendications précédentes, selon lequel il est alimenté par une tension d'entrée (Vin) et il comprend en outre un condensateur d'entrée (C2) pour emmagasiner de l'énergie à partir de la tension d'entrée (Vin).

8. Dispositif de détection (CAPT) de présence selon l'une des revendications précédentes, selon lequel il comprend en outre :
- des moyens de mesure associés (GA/GB ; TA/TB ; GAB ; TAB) à un organe de détection (EA, EB) pour générer une grandeur électrique de sortie (I_{A}-I_{B} ; U_{A}-U_{B} ; I_{AB} ; U_{AB}) lorsque ledit organe de détection (EA, EB) détecte la présence d'un objet (O).

9. Dispositif de détection (CAPT) de présence selon la revendication précédente, selon lequel il comprend en outre :
- des moyens d'inhibition (INH) pour inhiber des moyens de mesure (GA/GB ; TA/TB ; GAB ; TAB) de sorte qu'ils ne génèrent plus de grandeur électrique (I_{A}-I_{B} ; U_{A}-U_{B} ; I_{AB} ; U_{AB}).

10. Dispositif de détection (CAPT) de présence selon l'une des revendications précédentes 8 à 9 , selon lequel les moyens de mesure comprennent un générateur de courant associé (GA/GB) à chaque organe de détection (EA/EB), et une grandeur électrique de sortie est un courant de sortie générateur (I_{A}-I_{B}).

11. Dispositif de détection (CAPT) de présence selon l'une des revendications précédentes 8 à 10, selon lequel les moyens de mesure comprennent un unique générateur de courant (GAB) associé à tous les organes de détection (EA/EB), et une grandeur électrique de sortie est un courant de sortie générateur (I_{A}-I_{B}).

12. Dispositif de détection (CAPT) de présence selon l'une des revendications précédentes 8 à 11, selon lequel les moyens de mesure comprennent un interrupteur connecté à la masse associé (TA/TB) à chaque organe de détection (EA/EB), et une grandeur électrique de sortie est une tension de sortie générateur (U_{A}-U_{B}).

13. Dispositif de détection (CAPT) de présence selon l'une des revendications précédentes 8 à 12, selon lequel les moyens de mesure comprennent un unique interrupteur connecté à la masse (TAB) associé à tous les organes de détection, et une grandeur électrique de sortie est une tension de sortie générateur (U_{A}-U_{B}).

14. Dispositif de détection (CAPT) de présence selon l'une des revendications précédentes 4 à 13, selon lequel l'élément de détection basse fréquence (CMP) comporte un comparateur pour détecter une coupure d'alimentation dudit dispositif de détection (CAPT).

15. Dispositif de détection (CAPT) de présence selon la revendication précédente, selon lequel le comparateur (CMP) permet de comparer la tension (Vc2) aux bornes du condensateur d'entrée (C2) avec la tension d'entrée (Vin).

16. Dispositif de détection (CAPT) de présence selon l'une des revendications précédentes 14 à 15, selon lequel les moyens d'inhibition (INH) permettent d'inhiber des moyens de mesure (GA/GB ; TA/TB ; GAB ; TAB) lorsqu'une coupure d'alimentation dudit dispositif de détection (CAPT) est détectée.

17. Dispositif de détection (CAPT) de présence selon la revendication précédente, selon lequel les moyens d'inhibition (INH) permettent d'inhiber des moyens de mesure (GA/GB ; TA/TB ; GAB ; TAB) lorsque la tension d'entrée (Vin) est inférieure à la tension (Vc2) aux bornes du condensateur d'entrée (Vc2) moins un premier seuil (Vs1).

18. Dispositif de détection (CAPT) de présence selon l'une des revendications précédentes 14 à 17, selon lequel le dispositif de sauvegarde (LOGIC) sauvegarde la valeur du niveau de référence (REF) mesurée avant l'émission d'un signal basse fréquence (BF), jusqu'à ce que la tension d'entrée (Vin) soit supérieure à la tension (Vc2) aux bornes du condensateur d'entrée (C2) moins un deuxième seuil (Vs2).

19. Dispositif de détection (CAPT) de présence selon l'une des revendications précédentes 14 à 18, selon lequel il comporte en outre :
- un premier filtre temporel (TF1) pour mesurer la durée (T_{c}) de la coupure d'alimentation et n'autoriser la sauvegarde de la valeur du niveau de référence (REF) mesurée avant l'émission du signal basse fréquence (BF) que si ladite durée (T_{c}) est supérieure à un premier temps prédéterminé (Tp1).

20. Dispositif de détection CAPT) de présence selon l'une des revendications précédentes 14 à 19, selon laquelle il comporte en outre :
- un deuxième filtre temporel (TF2) pour libérer la sauvegarde de la valeur du niveau de référence (REF) mesurée avant l'émission du signal basse fréquence (BF), lorsque la tension d'entrée (Vin) est égale à la tension (Vc2) aux bornes du condensateur d'entrée (C2) pendant une durée (Tp2) supérieure à un deuxième temps prédéterminé (T_{BF}).

21. Dispositif de détection (CAPT) de présence selon l'une des revendications précédentes 4 à 13, selon lequel l'élément de détection basse fréquence (CMP) comporte un comparateur pour détecter un signal résonnant (Vbf) représentatif de l'émission d'un signal basse fréquence (BF).

22. Dispositif de détection (CAPT) de présence selon la revendication précédente, selon lequel l'élément de détection basse fréquence (CMP) comporte un détecteur crête (D3C) pour permettre une détection crête à partir du signal résonnant.

23. Dispositif de détection (CAPT) de présence selon la revendication précédente 21 ou 22, selon lequel le comparateur (CMP) permet de comparer une tension de résonance (Vbf) générée par une antenne (TX) et une tension de référence (Vref), ladite antenne (TX) permettant d'émettre le signal basse fréquence (BF).

24. Dispositif de détection (CAPT) de présence selon la revendication précédente 21 ou 22, selon lequel le signal résonnant est une tension image d'un courant résonnant (I_{BF}) circulant dans une antenne (TX) permettant d'émettre le signal basse fréquence (BF).

25. Dispositif de détection (CAPT) de présence selon l'une des revendications précédentes 21 à 24, selon lequel les moyens d'inhibition permettent d'inhiber (INH) des moyens de mesure (GA/GB ; TA/TB ; GAB ; TAB) lorsque que l'émission d'un signal basse fréquence (BF) est détectée.

26. Dispositif de détection (CAPT) de présence selon l'une des revendications précédentes 4 à 13, selon lequel l'élément de détection basse fréquence (CMP) comporte un comparateur pour détecter un signal d'entrée pulsé (Vin) représentatif de l'émission d'un signal basse fréquence (BF).

27. Dispositif de détection (CAPT) de présence selon la revendication précédente, selon lequel l'élément de détection basse fréquence (CMP) comporte un détecteur crête (D2C5) pour permettre une détection crête à partir du signal d'entrée pulsé (Vin).

28. Dispositif de détection (CAPT) de présence selon l'une des revendications précédentes 26 à 27, selon lequel l'élément de détection basse fréquence (CMP) comporte en outre un condensateur supplémentaire (C6).

29. Dispositif de détection (CAPT) de présence selon l'une des revendications précédentes 26 à 28, selon lequel l'élément de détection basse fréquence (CMP) comporte en outre une résistance supplémentaire (R9) qui associée à un condensateur (C5) permet une remise en route de la détection après l'émission d'un signal basse fréquence (BF).

30. Dispositif de détection (CAPT) de présence selon l'une des revendications précédentes 26 à 29, selon lequel le détecteur crête (D2C5) comporte une constante de temps (CT45) définie de manière à :
- minimiser le temps de détection de l'émission d'un signal basse fréquence (BF) en contrôlant le temps de charge dudit détecteur crête (R4C5).

31. Dispositif de détection (CAPT) de présence selon l'une des revendications précédentes 26 à 30, selon lequel le détecteur crête (D2C5) comporte une constante de temps (CT45) définie de manière à :
- éviter des pics de perturbations parasites transitoires du signal d'entrée pulsé (Vin) lors du chargement dudit détecteur crête (R4C5).

32. Unité de détection de présence (PSU) d'un objet (O), **caractérisé en ce qu'**elle comprend :
- un dispositif de détection (CAPT) selon l'une des revendications précédentes ; et
- une antenne (TX) pour émettre un signal basse fréquence (BF).

33. Procédé de détection de présence d'un objet (O) au moyen d'une grandeur physique (CE), associée à un organe de détection (EA, EB), qui varie en fonction de l'environnement où est placé ledit organe de détection (EA, EB), comprenant l'étape de
délivrer un niveau de référence (REF) variable de la grandeur physique (CE) et correspondant à l'absence d'un objet (O) ;
- sauvegarder, pendant l'émission d'un signal basse fréquence (BF), une valeur du niveau de référence (REF) mesurée avant l'émission dudit signal basse fréquence (BF) ;
**caractérisé en ce qu'**il comprend en outre les étapes de :
- mesurer la grandeur physique (CE) associée à l'organe de détection (EA/EB) ;
- comparer la grandeur physique (CE) à la valeur du niveau de référence (REF) sauvegardée ;
- suspendre la variation du niveau de référence (REF) dès que la présence d'un objet est détecté ou dès qu'un signal basse fréquence est émis ;
- libérer ladite sauvegarde après l'émission du signal basse fréquence (BF).

34. Produit programme (PG) d'ordinateur comportant une ou plusieurs séquences d'instructions exécutables par une unité de traitement d'information, l'exécution desdites séquences d'instructions permettant une mise en oeuvre du procédé selon la revendication précédente 33.

## Claims

1. Device (CAPT) for detecting the presence of an object (O), the device comprising at least one detection member (EA, EB) which has an associated physical quantity (CE) that varies according to the environment in which said detection member (EA, EB) is located,
the physical quantity (CE) delivers a variable reference level (REF) corresponding to the absence of an object (O);
the detection device also comprising:
- a saving device (LOGIC) for:
- saving, during the emission of a low-frequency signal (BF), a value of the reference level (REF) measured before the emission of said low-frequency signal (BF);
- measuring the physical quantity (CE) associated with the detection member (EA/EB);
- comparing the physical quantity (CE) to the saved value of the reference level (REF).
**characterized in that** the said saving device (LOGIC) is configured in such a way to:
- suspend the variation of the reference level (REF) as soon as the presence of an object is detected or as soon as a low-frequency signal is emitted;
- release said save after the emission of the low-frequency signal (BF).

2. Detection device (CAPT) according to Claim 1, wherein the physical quantity (CE) is a capacitance.

3. Detection device (CAPT) according to one of the preceding claims, wherein the physical quantity (CE) is a light flux.

4. Detection device (CAPT) according to one of the preceding claims, wherein it also comprises:
- a low-frequency detection element (CMP) detecting the start of emission of a low-frequency signal (BF).

5. Presence detection device (CAPT) according to one of the preceding claims, wherein it is powered by a power supply (Vin) common to an antenna (TX) for emitting a low-frequency signal (BF).

6. Detection device (CAPT) according to one of the preceding claims, wherein it is powered, during the emission of a low-frequency signal (BF), by an antenna (TX) excitation voltage, said antenna making it possible to emit the low-frequency signal (BF).

7. Presence detection device (CAPT) according to one of the preceding claims, wherein it is powered by an input voltage (Vin) and it also comprises an input capacitor (C2) for storing energy from the input voltage (Vin).

8. Presence detection device (CAPT) according to one of the preceding claims, wherein it also comprises:
- measuring means (GA/GB; TA/TB; GAB; TAB) associated with a detection member (EA, EB) for generating an output electrical quantity (I_{A}-I_{B}; U_{A}-U_{B}; I_{AB}; U_{AB}) when said detection member (EA, EB) detects the presence of an object (0).

9. Presence detection device (CAPT) according to the preceding claim, wherein it also comprises:
- inhibition means (INH) for inhibiting measuring means (GA/GB; TA/TB; GAB; TAB) so that they no longer generate any electrical quantity (I_{A}-I_{B}; U_{A}-U_{B}; I_{AB}; U_{AB}).

10. Presence detection device (CAPT) according to one of the preceding Claims 8 or 9, wherein the measuring means comprise a current generator (GA/GB) associated with each detection member (EA/EB), and an output electrical quantity is a generator output current (I_{A}-I_{B}).

11. Presence detection device (CAPT) according to one of the preceding Claims 8 to 10, wherein the measuring means comprise a single current generator (GAB) associated with all the detection members (EA/EB), and an output electrical quantity is a generator output current (I_{A}-I_{B}).

12. Presence detection device (CAPT) according to one of the preceding Claims 8 to 11, wherein the measuring means comprise a switch connected to ground (TA/TB) associated with each detection member (EA/EB), and an output electrical quantity is a generator output voltage (U_{A}-U_{B}).

13. Presence detection device (CAPT) according to one of the preceding Claims 8 to 12, wherein the measuring means comprise a single switch connected to ground (TAB) associated with all the detection members, and an output electrical quantity is a generator output voltage (U_{A}-U_{B}).

14. Presence detection device (CAPT) according to one of the preceding Claims 4 to 13, wherein the low-frequency detection element (CMP) comprises a comparator for detecting a break in the power supply to said detection device (CAPT).

15. Presence detection device (CAPT) according to the preceding claim, wherein the comparator (CMP) makes it possible to compare the voltage (Vc2) at the terminals of the input capacitor (C2) with the input voltage (Vin).

16. Presence detection device (CAPT) according to one of the preceding Claims 14 or 15, wherein the inhibition means (INH) make it possible to inhibit measuring means (GA/GB; TA/TB; GAB; TAB) when a break in the power supply to said detection device (CAPT) is detected.

17. Presence detection device (CAPT) according to the preceding claim, wherein the inhibition means (INH) make it possible to inhibit measuring means (GA/GB; TA/TB; GAB; TAB) when the input voltage (Vin) is less than the voltage (Vc2) at the terminals of the input capacitor (C2) minus a first threshold (Vs1).

18. Presence detection device (CAPT) according to one of the preceding Claims 14 to 17, wherein the saving device (LOGIC) saves the value of the reference level (REF) measured before the emission of a low-frequency signal (BF), until the input voltage (Vin) is greater than the voltage (Vc2) at the terminals of the input capacitor (C2) minus a second threshold (Vs2).

19. Presence detection device (CAPT) according to one of the preceding Claims 14 to 18, wherein it also comprises:
- a first time filter (TF1) for measuring the duration (T_{c}) of the break in power supply and allowing the value of the reference level (REF) measured before the emission of the low-frequency signal (BF) to be saved only if said duration (T_{C}) is greater than a first predetermined time (Tp1).

20. Presence detection device (CAPT) according to one of the preceding Claims 14 to 19, wherein it also comprises:
- a second time filter (TF2) for releasing the saving of the value of the reference level (REF) measured before the emission of the low-frequency signal (BF), when the input voltage (Vin) is equal to the voltage (Vc2) at the terminals of the input capacitor (C2) for a duration (Tp2) greater than a second predetermined time (T_{BF}).

21. Presence detection device (CAPT) according to one of the preceding Claims 4 to 13, wherein the low-frequency detection element (CMP) comprises a comparator for detecting a resonant signal (Vbf) representative of the emission of a low-frequency signal (BF).

22. Presence detection device (CAPT) according to the preceding claim, wherein the low-frequency detection element (CMP) comprises a peak level detector (D3C) to allow for a peak level detection from the resonant signal.

23. Presence detection device (CAPT) according to the preceding Claim 21 or 22, wherein the comparator (CMP) makes it possible to compare a resonant voltage (Vbf) generated by an antenna (TX) and a reference voltage (Vref), said antenna (TX) making it possible to emit the low-frequency signal (BF).

24. Presence detection device (CAPT) according to the preceding Claim 21 or 22, wherein the resonant signal is an image voltage of a resonant current (I_{BF}) circulating in an antenna (TX) making it possible to emit the low-frequency signal (BF).

25. Presence detection device (CAPT) according to one of the preceding Claims 21 to 24, wherein the inhibition means make it possible to inhibit (INH) measuring means (GA/GB; TA/TB; GAB; TAB) when the emission of a low-frequency signal (BF) is detected.

26. Presence detection device (CAPT) according to one of the preceding Claims 4 to 13, wherein the low-frequency detection element (CMP) comprises a comparator for detecting a pulsed input signal (Vin) representative of the emission of a low-frequency signal (BF).

27. Presence detection device (CAPT) according to the preceding claim, wherein the low-frequency detection element (CMP) comprises a peak level detector (D2C5) to allow for a peak level detection from the pulsed input signal (Vin).

28. Presence detection device (CAPT) according to one of the preceding Claims 26 or 27, wherein the low-frequency detection element (CMP) also comprises an additional capacitor (C6).

29. Presence detection device (CAPT) according to one of the preceding Claims 26 to 28, wherein the low-frequency detection element (CMP) also comprises an additional resistor (R9) which, associated with a capacitor (C5), allows for the detection to be restarted after the emission of a low-frequency signal (BF).

30. Presence detection device (CAPT) according to one of the preceding Claims 26 to 29, wherein the peak level detector (D2C5) comprises a time constant (CT45) defined so as to:
- minimize the time to detect the emission of a low-frequency signal (BF) by controlling the charging time of said peak level detector (R4C5).

31. Presence detection device (CAPT) according to one of the preceding Claims 26 to 30, wherein the peak level detector (D2C5) comprises a time constant (CT45) defined so as to:
- avoid transient spurious disturbance peaks on the pulsed input signal (Vin) when charging said peak level detector (R4C5).

32. Unit (PSU) for detecting the presence of an object (O), **characterized in that** it comprises:
- a detection device (CAPT) according to one of the preceding claims; and
- an antenna (TX) for emitting a low-frequency signal (BF).

33. Method for detecting the presence of an object (O) by means of a physical quantity (CE), associated with a detection member (EA, EB), which varies according to the environment in which said detection member (EA, EB) is located, comprising the step for
delivering a variable reference level (REF) of the physical quantity (CE) corresponding to the absence of an object (O);
- saving, during the emission of a low-frequency signal (BF), a value of the reference level (REF) measured before the emission of said low-frequency signal (BF);
- measuring the physical quantity (CE) associated with the detection member (EA/EB);
- comparing the physical quantity (CE) to the
saved value of the reference level (REF); **characterized in that** it also comprises the steps for:
- suspending the variation of the reference level (REF) as soon as the presence of an object is detected or as soon as a low-frequency signal is emitted;
- releasing said save after the emission of the low-frequency signal (BF).

34. Computer program product (PG) comprising one or more sequences of instructions that can be executed by an information processing unit, the execution of said sequences of instructions making it possible to implement the method according to the preceding Claim 33.

## Patentansprüche

1. Vorrichtung zur Erfassung (CAPT) der Präsenz eines Objekts (O), wobei die Vorrichtung mindestens ein Erfassungselement (EA, EB) aufweist, welchem eine physikalische Größe (CE) zugeordnet ist, die in Abhängigkeit von der Umgebung, in der sich das Erfassungselement (EA, EB) befindet, variiert,
wobei die physikalische Größe (CE) einen Referenzpegel (REF) bereitstellt, der variabel ist und der Abwesenheit eines Objekts (O) entspricht;
wobei die Vorrichtung zur Erfassung außerdem aufweist:
- eine Speichervorrichtung (LOGIC) zum:
- Speichern, während der Aussendung eines Niederfrequenzsignals (BF), eines Wertes des Referenzpegels (REF), der vor der Aussendung des Niederfrequenzsignals (BF) gemessen wurde;
- Messen der physikalischen Größe (CE), die dem Erfassungselement (EA, EB) zugeordnet ist;
- Vergleichen der physikalischen Größe (CE) mit dem gespeicherten Wert des Referenzpegels (REF);
**dadurch gekennzeichnet, dass** die Speichervorrichtung (LOGIC) dafür ausgebildet ist,
- die Änderung des Referenzpegels (REF) zeitweilig zu verhindern, sobald die Präsenz eines Objekts erfasst wird oder sobald ein Niederfrequenzsignal ausgesendet wird;
- die Speicherung nach der Aussendung des Niederfrequenzsignals (BF) wieder freizugeben.

2. Vorrichtung zur Erfassung (CAPT) nach Anspruch 1, wobei die physikalische Größe (CE) eine Kapazität ist.

3. Vorrichtung zur Erfassung (CAPT) nach einem der vorhergehenden Ansprüche, wobei die physikalische Größe (CE) ein Lichtstrom ist.

4. Vorrichtung zur Erfassung (CAPT) nach einem der vorhergehenden Ansprüche, welche außerdem aufweist:
- ein Niederfrequenz-Erfassungselement (CMP) zur Erfassung des Beginns der Aussendung eines Niederfrequenzsignals (BF).

5. Vorrichtung zur Erfassung (CAPT) der Präsenz nach einem der vorhergehenden Ansprüche, welche durch eine mit einer Antenne (TX) zur Aussendung eines Niederfrequenzsignals (BF) gemeinsame Spannungsversorgung (Vin) gespeist wird.

6. Vorrichtung zur Erfassung (CAPT) nach einem der vorhergehenden Ansprüche, welche während der Aussendung eines Niederfrequenzsignals (BF) durch eine Erregungsspannung einer Antenne (TX) gespeist wird, wobei die Antenne ermöglicht, das Niederfrequenzsignal (BF) auszusenden.

7. Vorrichtung zur Erfassung (CAPT) der Präsenz nach einem der vorhergehenden Ansprüche, welche durch eine Eingangsspannung (Vin) gespeist wird und welche außerdem einen Eingangskondensator (C2) aufweist, um ausgehend von der Eingangsspannung (Vin) Energie zu speichern.

8. Vorrichtung zur Erfassung (CAPT) der Präsenz nach einem der vorhergehenden Ansprüche, welche außerdem aufweist:
- Messmittel (GA/GB; TA/TB; GAB; TAB), die einem Erfassungselement (EA, EB) zugeordnet sind, zum Erzeugen einer elektrischen Ausgangsgröße (I_{A}-I_{B}; U_{A}-U_{B}; I_{AB}; U_{AB}), wenn das Erfassungselement (EA, EB) die Präsenz eines Objekts (O) erfasst.

9. Vorrichtung zur Erfassung (CAPT) der Präsenz nach dem vorhergehenden Anspruch, welche außerdem aufweist:
- Blockiermittel (INH) zum Blockieren der Messmittel (GA/GB; TA/TB; GAB; TAB), derart, dass sie keine elektrische Größe (I_{A}-I_{B}; U_{A}-U_{B}; I_{AB}; U_{AB}) mehr erzeugen.

10. Vorrichtung zur Erfassung (CAPT) der Präsenz nach einem der vorhergehenden Ansprüche 8 bis 9, wobei die Messmittel einen zugeordneten Stromgenerator (GA/GB) für jedes Erfassungselement (EA/EB) aufweisen und eine elektrische Ausgangsgröße ein Generatorausgangsstrom (I_{A}-I_{B}) ist.

11. Vorrichtung zur Erfassung (CAPT) der Präsenz nach einem der vorhergehenden Ansprüche 8 bis 10, wobei die Messmittel einen einzigen Stromgenerator (GAB) aufweisen, der allen Erfassungselementen (EA/EB) zugeordnet ist, und eine elektrische Ausgangsgröße ein Generatorausgangsstrom (I_{A}-I_{B}) ist.

12. Vorrichtung zur Erfassung (CAPT) der Präsenz nach einem der vorhergehenden Ansprüche 8 bis 11, wobei die Messmittel einen zugeordneten mit der Masse verbundenen Schalter (TA/TB) für jedes Erfassungselement (EA/EB) aufweisen und eine elektrische Ausgangsgröße eine Generatorausgangsspannung (U_{A}-U_{B}) ist.

13. Vorrichtung zur Erfassung (CAPT) der Präsenz nach einem der vorhergehenden Ansprüche 8 bis 12, wobei die Messmittel einen einzigen mit der Masse verbundenen Schalter (TAB) aufweisen, der allen Erfassungselementen zugeordnet ist, und eine elektrische Ausgangsgröße eine Generatorausgangsspannung (U_{A}-U_{B}) ist.

14. Vorrichtung zur Erfassung (CAPT) der Präsenz nach einem der vorhergehenden Ansprüche 4 bis 13, wobei das Niederfrequenz-Erfassungselement (CMP) einen Komparator aufweist, um eine Unterbrechung der Stromversorgung der Vorrichtung zur Erfassung (CAPT) zu erfassen.

15. Vorrichtung zur Erfassung (CAPT) der Präsenz nach dem vorhergehenden Anspruch, wobei der Komparator (CMP) es ermöglicht, die Spannung (Vc2) an den Klemmen des Eingangskondensators (C2) mit der Eingangsspannung (Vin) zu vergleichen.

16. Vorrichtung zur Erfassung (CAPT) der Präsenz nach einem der vorhergehenden Ansprüche 14 bis 15, wobei die Blockiermittel (INH) ermöglichen, Messmittel (GA/GB; TA/TB; GAB; TAB) zu blockieren, wenn eine Unterbrechung der Stromversorgung der Vorrichtung zur Erfassung (CAPT) erfasst wird.

17. Vorrichtung zur Erfassung (CAPT) der Präsenz nach dem vorhergehenden Anspruch, wobei die Blockiermittel (INH) ermöglichen, Messmittel (GA/GB; TA/TB; GAB; TAB) zu blockieren, wenn die Eingangsspannung (Vin) kleiner als die Spannung (Vc2) an den Klemmen des Eingangskondensators (C2) abzüglich eines ersten Schwellenwertes (Vs1) ist.

18. Vorrichtung zur Erfassung (CAPT) der Präsenz nach einem der vorhergehenden Ansprüche 14 bis 17, wobei die Speichervorrichtung (LOGIC) den Wert des Referenzpegels (REF), der vor der Aussendung eines Niederfrequenzsignals (BF) gemessen wurde, speichert, bis die Eingangsspannung (Vin) größer als die Spannung (Vc2) an den Klemmen des Eingangskondensators (C2) abzüglich eines zweiten Schwellenwertes (Vs2) ist.

19. Vorrichtung zur Erfassung (CAPT) der Präsenz nach einem der vorhergehenden Ansprüche 14 bis 18, welche außerdem aufweist:
- ein erstes Zeitfilter (TF1) zum Messen der Dauer (T_{c}) der Unterbrechung der Stromversorgung und Erlauben der Speicherung des Wertes des Referenzpegels (REF), der vor der Aussendung des Niederfrequenzsignals (BF) gemessen wurde, nur dann, wenn die Dauer (T_{c}) größer als eine vorbestimmte erste Zeit (Tp1) ist.

20. Vorrichtung zur Erfassung (CAPT) der Präsenz nach einem der vorhergehenden Ansprüche 14 bis 19, welche außerdem aufweist:
- ein zweites Zeitfilter (TF2) zum Freigeben der Speicherung des Wertes des Referenzpegels (REF), der vor der Aussendung des Niederfrequenzsignals (BF) gemessen wurde, wenn die Eingangsspannung (Vin) während einer Dauer (Tp2), die größer als eine vorbestimmte zweite Zeit (T_{BF}) ist, gleich der Spannung (Vc2) an den Klemmen des Eingangskondensators (C2) ist.

21. Vorrichtung zur Erfassung (CAPT) der Präsenz nach einem der vorhergehenden Ansprüche 4 bis 13, wobei das Niederfrequenz-Erfassungselement (CMP) einen Komparator zum Erfassen eines Resonanzsignals (Vbf) aufweist, das für die Aussendung eines Niederfrequenzsignals (BF) repräsentativ ist.

22. Vorrichtung zur Erfassung (CAPT) der Präsenz nach dem vorhergehenden Anspruch, wobei das Niederfrequenz-Erfassungselement (CMP) einen Spitzenwertdetektor (D3C) aufweist, um eine Spitzenwertdetektion ausgehend von dem Resonanzsignal zu ermöglichen.

23. Vorrichtung zur Erfassung (CAPT) der Präsenz nach dem vorhergehenden Anspruch 21 oder 22, wobei der Komparator (CMP) ermöglicht, eine von einer Antenne (TX) erzeugte Resonanzspannung (Vbf) und eine Referenzspannung (Vref) zu vergleichen, wobei die Antenne (TX) ermöglicht, das Niederfrequenzsignal (BF) auszusenden.

24. Vorrichtung zur Erfassung (CAPT) der Präsenz nach dem vorhergehenden Anspruch 21 oder 22, wobei das Resonanzsignal eine Spannung ist, die zu einem Resonanzstrom (I_{BF}) proportional ist, der in einer Antenne (TX) zirkuliert, die es ermöglicht, das Niederfrequenzsignal (BF) auszusenden.

25. Vorrichtung zur Erfassung (CAPT) der Präsenz nach einem der vorhergehenden Ansprüche 21 bis 24, wobei die Blockiermittel (INH) es ermöglichen, Messmittel (GA/GB; TA/TB; GAB; TAB) zu blockieren, wenn die Aussendung eines Niederfrequenzsignals (BF) erfasst wird.

26. Vorrichtung zur Erfassung (CAPT) der Präsenz nach einem der vorhergehenden Ansprüche 4 bis 13, wobei das Niederfrequenz-Erfassungselement (CMP) einen Komparator zum Erfassen eines gepulsten Eingangssignals (Vin) aufweist, das für die Aussendung eines Niederfrequenzsignals (BF) repräsentativ ist.

27. Vorrichtung zur Erfassung (CAPT) der Präsenz nach dem vorhergehenden Anspruch, wobei das Niederfrequenz-Erfassungselement (CMP) einen Spitzenwertdetektor (D2C5) aufweist, um eine Spitzenwertdetektion ausgehend von dem gepulsten Eingangssignal (Vin) zu ermöglichen.

28. Vorrichtung zur Erfassung (CAPT) der Präsenz nach einem der vorhergehenden Ansprüche 26 bis 27, wobei das Niederfrequenz-Erfassungselement (CMP) außerdem einen zusätzlichen Kondensator (C6) aufweist.

29. Vorrichtung zur Erfassung (CAPT) der Präsenz nach einem der vorhergehenden Ansprüche 26 bis 28, wobei das Niederfrequenz-Erfassungselement (CMP) außerdem einen zusätzlichen Widerstand (R9) aufweist, welcher gemeinsam mit einem Kondensator (C5) eine Wiederaufnahme der Erfassung nach der Aussendung eines Niederfrequenzsignals (BF) ermöglicht.

30. Vorrichtung zur Erfassung (CAPT) der Präsenz nach einem der vorhergehenden Ansprüche 26 bis 29, wobei der Spitzenwertdetektor (D2C5) eine Zeitkonstante (CT45) aufweist, die derart definiert ist, dass:
- die Erfassungszeit der Aussendung eines Niederfrequenzsignals (BF) minimiert wird, indem die Ladezeit des Spitzenwertdetektors (R4C5) gesteuert wird.

31. Vorrichtung zur Erfassung (CAPT) der Präsenz nach einem der vorhergehenden Ansprüche 26 bis 30, wobei der Spitzenwertdetektor (D2C5) eine Zeitkonstante (CT45) aufweist, die derart definiert ist, dass:
- Spitzen von transienten Störungen des gepulsten Eingangssignals (Vin) beim Laden des Spitzenwertdetektors (R4C5) vermieden werden.

32. Einheit zur Erfassung der Präsenz (PSU) eines Objekts (O), **dadurch gekennzeichnet, dass** sie aufweist:
- eine Vorrichtung zur Erfassung (CAPT) nach einem der vorhergehenden Ansprüche; und
- eine Antenne (TX) zum Aussenden eines Niederfrequenzsignals (BF).

33. Verfahren zur Erfassung der Präsenz eines Objekts (O) mittels einer einem Erfassungselement (EA, EB) zugeordneten physikalischen Größe (CE), die in Abhängigkeit von der Umgebung, in der sich das Erfassungselement (EA, EB) befindet, variiert, welches den Schritt aufweist:
Bereitstellen eines variablen Referenzpegels (REF) der physikalischen Größe (CE), welcher der Abwesenheit eines Objekts (O) entspricht;
- Speichern, während der Aussendung eines Niederfrequenzsignals (BF), eines Wertes des Referenzpegels (REF), der vor der Aussendung des Niederfrequenzsignals (BF) gemessen wurde;
- Messen der physikalischen Größe (CE), die dem Erfassungselement (EA, EB) zugeordnet ist;
- Vergleichen der physikalischen Größe (CE) mit dem gespeicherten Wert des Referenzpegels (REF);
**dadurch gekennzeichnet, dass** es außerdem die folgenden Schritte aufweist:
- zeitweiliges Verhindern der Änderung des Referenzpegels (REF), sobald die Präsenz eines Objekts erfasst wird oder sobald ein Niederfrequenzsignal ausgesendet wird;
- Freigeben der Speicherung nach der Aussendung des Niederfrequenzsignals (BF).

34. Computerprogrammprodukt (PG), das eine oder mehrere Folgen von Anweisungen aufweist, die durch eine Informationsverarbeitungseinheit ausführbar sind, wobei die Ausführung dieser Folgen von Anweisungen eine Durchführung des Verfahrens nach dem vorhergehenden Anspruch 33 ermöglicht.
